(19)

Europäisches
Patentamt
European
Patent Office
Office européen
des brevets

(11)     **EP 1 701 170 B1**

(12)                  **EUROPEAN PATENT SPECIFICATION**

(45) Date of publication and mention
of the grant of the patent:
**19.09.2012   Bulletin 2012/38**

(51) Int Cl.:
***G01R 23/167*** (2006.01)

(21) Application number: **06004474.0**

(22) Date of filing: **06.03.2006**

(54) **Signal measuring/analyzing apparatus and  method**

Vorrichtung und Verfahren zur Signalmessung/Signalanalyse

Appareil et procédé de mesure  et d'analyse de signaux

(84) Designated Contracting States:
**DE GB**

(30) Priority:  **09.03.2005   JP 2005065313**

(43) Date of publication of application:
**13.09.2006   Bulletin 2006/37**

(73) Proprietor: **Anritsu Corporation**
**Atsugi-shi**
**Kanagawa 243-8555 (JP)**

(72) Inventor: **Uchino, Masaharu**
**Atsugi-shi,**
**Kanagawa, 243-8555 (JP)**

(74) Representative: **Pautex Schneider, Nicole**
**Véronique et al**
**Novagraaf International SA**
**Chemin de l'Echo 3**
**1213 Onex (CH)**

(56) References cited:
**WO-A-01/37502      US-A- 4 771 232**

- **UCHINO M ET AL: "ON PULSE DURATION DISTRIBUTION MEASURING CIRCUIT WITH WIDE DURATION RANGE" DENSHI JOHO TSUSHIN GAKKAI RONBUNSHI. B-1, TOKYO, JP, vol. J82-B, no. 8, August 1999 (1999-08), pages 1596-1601, XP008064434 ISSN: 0915-1877**

**Description**

The present invention relates to a signal measuring/analyzing apparatus and signal measuring/analyzing method, and more particularly, to a signal measuring/analyzing apparatus and signal measuring/analyzing method employing a technique that causes a digital circuit to perform logarithmic conversion of digital data related to a signal, a technique that interpolates data of sampling operations, and a measuring technique using these techniques in a signal measuring apparatus/method which samples a signal to convert the signal into digital data, detects the digital data, converts the digital data into a logarithm, and measures the magnitude of the logarithm and a signal analyzing apparatus/method which analyzes a probability of generating the signal and a frequency of the signal. The document US 4 771 232 describes a non-interruptive spectrum analyzer for digital modems.

In the conventional signal measuring/analyzing apparatus and signal measuring/analyzing method as described above, a level (power) of a signal is measured to display (output) the level in a unit of dB (decibel). For this reason, after a signal is detected by a detector, the detection output is converted into a logarithm by a log (LOG) converter using log conversion (to be also referred to as "logarithmic amplification").

In order to perform log conversion of digital data $\rho$ of quadrature components I and Q obtained by, for example, an IF detecting unit such as spectrum analyzer which is a kind of a signal measuring/analyzing apparatus, $p = I^2 + Q^2$ is a positive integer of $2^{31}$ or less when the data is expressed by a 16-bit signed integer (integer ranging from $-2^{15}$ or more and $2^{15}-1$ or less). Therefore, the data is expressed by a 32-bit positive integer (integer ranging from 0 or more and $2^{32}-1$ or less).

However, if it is assumed that the resolution of the logarithm is set at 16 bits in this case, a large amount of memory capacity corresponding to $2^{31}$ words is required when log conversion is simply tried to be performed. For this reason, it is problematic that the log conversion is not easily realized by an ordinary memory.

A conventional log converter is generally constituted by using analog electronic parts realized by semiconductor elements.

However, the log converter using the analog electronic parts easily has fluctuations in linearity of logarithmic conversion (log) characteristics (input-to-output characteristics of the log converter), an offset value, and the like, and problematically easily influenced by the ambient environment (see Jpn. Pat. Appln. KOKAI Publication No. 9-257843 (Patent Document 1) and Jpn. Pat. Appln. KOKAI Publication No. 7-321582 (Patent Document 2)).

In Patent Document 1, in order to make it easy to proof a device including such a log converter, a digital signal processor (DSP) which is a kind of a high-speed CPU is caused to execute a program including a procedure of a log converting process with respect to digital data generated by sampling from a signal.

In Patent Document 2, a correcting operation to convert the digital data generated by sampling into a log characteristic is performed.

According to Patent Document 1, the method is realized by software using a CPU for a high-speed operation although linearity or stability is improved. For this reason, processing time required to execute a program is so long to cause a problem.

In particular, in the method, long processing time poses a problem in an amplitude probability distribution (APD) measurement (see Jpn. Pat. Appln. KOKAI Publication No. 10-170574 (Patent Document 3)) or the like which sequentially measures an electromagnetic wave (interference wave) generated by a spectrum analyzer which measures a varying electric wave signal or an electronic device to perform a statistic process.

According to Patent Document 2, target data is corrected without using a log converter itself to obtain linearity which is a log characteristic, and thus, the corrected target data is dependent on another circuit. For this reason, correction data must be acquired for each device having a logarithmic converter to perform correction.

Since, in any of the documents described above, sampling is performed at clocks generated in a predetermined cycle ts by an analog/digital (A/D) converter to convert analog data into digital data, data between the clocks is disadvantageously dropped out.

For example, there is a spectrum analyzer which performs display such that a level of a signal having a frequency selectively received while performing frequency sweep and a receiving frequency (measured frequency) are set on an ordinate and an abscissa, respectively. In this case, when measurement display is performed in accordance with a frequency in each clock, a frequency between the clocks and data of the level corresponding to the frequency are consequently dropped out.

Even if there is an electric wave having a peak value between clocks in such a spectrum analyzer, the electric wave may not be measured.

In this case, in a conventional spectrum analyzer, measurement is performed while decreasing a frequency span of a clock unit (the frequency span is enlarged on display), so that an electric wave is captured.

However, in a method of capturing such an electric wave has a problem of long processing time required for measurement.

In order to solve the problems of the prior art described above, it is an object of the present invention to provide a signal measuring/analyzing apparatus and a signal measuring/analyzing method such as amplitude probability distribution measurement or a spectrum analyzer which employs a technique which can rapidly obtain a preferably log characteristic in a digitally hardware configuration by means of, for example, a logical circuit and employs a technique which calculates digital data set in a sampling interval by interpolation to minimize a memory capacity and to make it possible to perform high-speed processing.

The present invention is defined in the appended claims.

In order to achieve the above object, the invertor of the present application has interested in an invention described in Japanese Patent No. 2920828 (Japanese Patent Application No. 10-164260 and Jpn. Pat. Appln. KOKAI Publication No. 11-337600) (Patent Document 4) in which himself has participated to try to improve the invention such that the invention can be applied to log conversion in level measurement.

In Patent Document 4, in order to measure a time interval of signals of an electromagnetic interference wave or the like directly regardless of level measurement, an electromagnetic interference wave is binarized by a predetermined threshold value, and resultant binary values are counted by a binary-coded counter to convert the values into time-series bit data. Thereafter, a logarithm is acquired.

In this case, in Patent Document 4, the logarithm is acquired to minimize wide-range time intervals ranging from a narrow time interval to a wide time interval of signals and a memory capacity and to measurement at a high speed.

The contents of Patent Document 4 are also disclosed in Non-patent Document 1 (IEEE TRANSACTIONS ON ELECTROMAGNETIC COMPATIBILITY, VOL. 43, NO. 4, NOVEMBER 2001 "Real-time Measurement of Noise Statistics", Masaharu Uchino et al, pp. 629 to 636) and Non-patent Document 2 (EMC '99 Tokyo International Symposium On Electromagnetic Compatibility, May 1999, "SIMULTANEOUS MEASUREMENTS of DISTURBANCE APD, CRD and PDD", Masaharu Uchino et al, pp. 177 to 180).

Therefore, in this specification, the contents disclosed in Non-patent Document 1 and Non-patent Document 2 will be referred to in relation to the contents of Patent Document 4.

In the present invention, the technique of acquiring a logarithm described in Patent Document 4 can be made possible to be applied to log conversion in level measurement of a signal by the following concrete configuration.

In order to achieve the above object, according to a first aspect of the present invention, there is provided a signal measuring apparatus comprising:

a data converting unit (100) which converts an input signal into digital data having a predetermined number of bits with clocks having a predetermined cycle ts and performs squared detection of the digital data to output the resultant data as phase-detected data;

an exponent-mantissa separator (210) which receives the phase-detected data output from the data converting unit and separates the phase-detected data into mantissa data expressing a mantissa part of the phase-detected data and exponent data expressing an exponent part of the phase-detected data to output the mantissa data and the exponent data;

a mantissa calculating table (220) which is accessed by the mantissa data output from the exponent-mantissa separator and which outputs a logarithm corresponding to the mantissa data stored in advance;

an exponent output unit (230) which outputs a logarithm corresponding to the exponent data based on the exponent data output from the exponent-mantissa separator; and

an adder (240) which, in order to obtain an output logarithm corresponding to the amplitude of the input signal, adds the logarithm corresponding to the mantissa data output from the mantissa calculating table to the logarithm corresponding to the exponent data output from the exponent output unit and outputs an output logarithm corresponding to the phase-detected data.

In order to achieve the above object, according to a second aspect of the present invention, there is provided the signal measuring apparatus according to the first aspect, wherein the exponent output unit comprises:

an exponent calculating table (230) which is accessed by the exponent data output from the exponent-mantissa separator and which outputs a logarithm corresponding to the exponent data stored in advance.

In order to achieve the above object, according to a third aspect of the present invention, there is provided the signal measuring apparatus according to the first aspect, wherein the exponent-mantissa separator comprises:

a decider (211) which receives the phase-detected data output from the data converting unit, discriminates a most significant bit of the phase-detected data in when receiving by using a logical circuit (211a, 211b), and outputs a discrimination result;

a mantissa selector (212) which selects data of a plurality of bits including data of a predetermined number of lower bits from the discrimination result of the most significant bit output from the decider and outputs the data as mantissa data expressing the mantissa part based on plurality of selected bit data; and

an exponent determiner (213) which converts the most significant bit into identifiable identification data based on the discrimination result of the most significant bit output from the decider and outputs the identification data as the exponent data expressing the exponent part.

In order to achieve the above object, according to a fourth aspect of the present invention, there is provided the signal measuring apparatus according to the first aspect, further comprising:

an interpolating unit (500) inserted between the data converting unit and the mantissa-exponent separator, the interpolating unit receiving the clocks having the predetermined cycle ts, interpolating the phase-detected data output from the data converting unit at an interval of 1/N in the predetermined cycle ts, and transmitting an interpolated value to the exponent-mantissa separator.

In order to achieve the above object, according to a fifth aspect of the present invention, there is provided the signal measuring apparatus according to the fourth aspect, wherein
the interpolating unit is configured to designate phase-detected data at a center (mts) of a range to be interpolated by the phase-detected data output at intervals of 1/N in the predetermined cycle ts, generate an extraction signal (mts+p, p is an integer ranging from 0 to N/2) having a cycle ts/N in the range to be interpolated, weight the phase-detected data $\{\rho(mts)\}$ at the center of the range to be interpolated and nearest phase-detected data $\{\rho((m-1)ts), \rho((m+1)ts)\}$ corresponding to width ($\pm p$) of a space between the extraction signal and the center in the range to be interpolated, and generate the interpolated value every extraction signal based on weighted values.

In order to achieve the above object, according to a sixth aspect of the present invention, there is provided the signal measuring apparatus according to the first aspect, wherein
the data converting unit comprises:

an analog/digital (A/D) converting unit (110) which converts the input signal into digital data having the predetermined number of bits with the clocks having the predetermined cycle ts;

a quadrature detecting unit (121) which performs a mixing operation to each component obtained by branching an output from the A/D converting unit into two components independently of two local signals having phases different from each other by 90° and each having a predetermined frequency and outputs two quadrature components having phases orthogonalized at a frequency corresponding to a difference between the frequency of the input signal and the predetermined frequency;

a resolution bandwidth (RBW) filter unit (122) which performs predetermined bandwidth limitation to the two quadrature components output from the quadrature detecting unit and outputs two bandwidth limitation resultant quadrature components;

a square detecting unit (123) which performs square detection to the two bandwidth limitation resultant quadrature components output from the RBW filter unit and outputs two square detection resultant quadrature components; and

an adding unit (124) which adds the two square detection resultant quadrature components output from the square detecting unit.

In order to achieve the above object, according to a seventh aspect of the present invention, there is provided the signal measuring apparatus according to the first aspect, further comprising:

an amplitude probability measuring unit (300),
the amplitude probability measuring unit comprising:

a memory (310) which is accessed by using the output logarithm output from the adder as an address value (k) and which outputs data corresponding to the output logarithm stored in advance to the address;

a data converter (320) which receives data $\{G^{n-1}(k)$ : n is the number of times of access up to the previous access} at the address output from the memory, converts the data into data $\{G^n(k)\}$ including information expressing the number of times of the latest access, and stores the data at identical address in the memory;

a frequency extracting unit (330) which receives the latest data $G^n(k)$ output from the memory, converts the data into the number of times $\{n(k)\}$ of access performed to addresses by the output logarithm, and outputs the number of times; and

an amplitude probability calculating unit (340) which calculates an amplitude probability based on the number of times $\{n(k)\}$ of access performed by the output logarithm output from the frequency extracting unit and outputs the amplitude probability.

In order to achieve the above object, according to an eighth aspect of the present invention, there is provided a signal analyzing apparatus comprising:

an RF unit (900) which sweeps a desired frequency bandwidth to an input high-frequency (RF) signal, and thereby converts the input RF signal selectively received into a predetermined intermediate-frequency (IF) signal and outputs an IF signal;
an A/D converting unit (110) which analog/digital-converts the IF signal output from the RF unit at clocks generated in the predetermined cycle ts and outputs the digital signal as digital data having a predetermined number of bits;
an IF detecting unit (120) comprising:

a quadrature detecting unit (121) which performs a mixing operation to each component obtained by branching an output from the A/D converting unit into two components independently of two local signals having phases different from each other by 90° and each having a predetermined frequency and outputs two quadrature components having phases orthogonalized at a frequency corresponding to a difference between the frequency of the input signal and the predetermined frequency;
a resolution bandwidth (RBW) filter unit (122) which performs predetermined bandwidth limitation to the two quadrature components output from the quadrature detecting unit and outputs two bandwidth limitation resultant quadrature components;
a square detecting unit (123) which performs square detection to the two bandwidth limitation quadrature components output from the RBW filter unit and outputs two square detection resultant quadrature components; and
an adding unit (124) which adds the two square detection resultant quadrature components output from the square detecting unit and outputs phase-detected data;

a log converting unit (200) comprising:

an exponent-mantissa separator (210) which receives the phase-detected data output from the adding unit of the IF detecting unit and separates the phase-detected data into mantissa data expressing a mantissa part of the phase-detected data and exponent data expressing an exponent part of the phase-detected data to output the mantissa data and the exponent data;
a mantissa calculating table (220) which is accessed by the mantissa data output from the exponent-mantissa separator and which outputs a logarithm corresponding to the mantissa data stored in advance;
an exponent output unit (230) which outputs a logarithm corresponding to the exponent data based on the exponent data output from the exponent-mantissa separator; and
an adder (240) which adds the logarithm corresponding to the mantissa data output from the mantissa calculating table to the logarithm corresponding to the exponent data output from the exponent output unit and outputs a logarithm corresponding to the phase-detected data; and

a display control unit (400) which displays the logarithm corresponding to the phase-detected data output from the adder of the log converting unit on a display unit (600).

In order to achieve the above object, according to a ninth aspect of the present invention, there is provided the signal analyzing apparatus according to the eighth aspect, wherein
the exponent output unit comprises:

an exponent calculating table (230) which is accessed by the exponent data output from the exponent-mantissa separator and which outputs a logarithm corresponding to the exponent data stored in advance.

In order to achieve the above object, according to a tenth aspect of the present invention, there is provided the signal analyzing apparatus according to the eighth aspect, further comprising:

an amplitude probability measuring unit (300),
the amplitude probability measuring unit comprising:

a memory (310) which is accessed by using the output logarithm output from the adder of the log converting unit as an address value (k) and which outputs data corresponding to the output logarithm stored in advance to the address;

a data converter (320) which receives data {$G^{n-1}(k)$ : n is the number of times of access up to the previous access} at the address output from the memory, converts the data into data {$G^n(k)$} including information expressing the number of times of the latest access, and stores the data at identical address in the memory;

a frequency extracting unit (330) which receives the latest data $G^n(k)$ output from the memory, converts the data into the number of times {n(k)} of access performed to addresses by the output logarithm, and outputs the number of times; and

an amplitude probability calculating unit (340) which calculates an amplitude probability of the input RF signal selectively received by the RF unit based on the number of times {n(k)} of access performed by the output logarithm output from the frequency extracting unit, and outputs the amplitude probability, wherein

the display control unit is configured to cause the display unit to selectively display the logarithm corresponding to the phase-detected data output from the adder of the log converting unit or the amplitude probability output from the amplitude probability calculating unit of the amplitude probability measuring unit on coordinates taking the abscissa of which indicates frequencies in the desired frequency bandwidth.

In order to achieve the above object, according to an eleventh aspect of the present invention, there is provided the signal analyzing apparatus according to the tenth aspect, further comprising:

an interpolating unit (500) inserted between the IF detecting unit and the log converting unit, the interpolating unit for receiving the clocks having the predetermined cycle ts, interpolating the phase-detected data output from the adder of the IF detecting unit at an interval of 1/N in the predetermined cycle ts, and transmitting an interpolated value to the exponent-mantissa separator of the log converting unit, wherein

the display control unit is configured to selectively display the logarithm depending on the phase-detected data output from the adder of the log converting unit or the amplitude probability output from the amplitude probability calculating unit of the amplitude probability measuring unit such that the frequencies in the desired frequency bandwidth on the abscissa are displayed by any of frequencies corresponding to an interval of the predetermined cycle ts and frequencies corresponding to an interval of a cycle ts/N.

In order to achieve the above object, according to a twelfth aspect of the present invention, there is provided the signal analyzing apparatus according to the eleventh aspect, wherein

the display control unit is configured to selectively display the logarithm corresponding to the phase-detected data output from the adder of the log converting unit or the amplitude probability output from the amplitude probability calculating unit of the amplitude probability measuring unit such that the frequencies in the desired frequency bandwidth on the abscissa are displayed by frequencies corresponding to an interval of the predetermined cycle ts and some of the frequencies are magnified and displayed by the frequencies corresponding to the interval of the cycle ts/N.

In order to achieve the above object, according to a thirteenth aspect of the present invention, there is provided the signal analyzing apparatus according to the eleventh aspect, wherein

the interpolating unit is configured to designate phase-detected data at a center (mts) of a range to be interpolated by the phase-detected data output at intervals of 1/N in the predetermined cycle ts, generate an extraction signal (mts$\pm$p, p is an integer ranging from 0 to N/2) having a cycle ts/N in the range to be interpolated, weight the phase-detected data {$\rho$(mts)} at the center of the range to be interpolated and nearest phase-detected data {$\rho$((m-1)ts), $\rho$((m+1)ts)} corresponding to width ($\pm$p) of a space between the extraction signal and the center in the range to be interpolated, and generate the interpolated value every extraction signal based on weighted values.

In order to achieve the above object, according to a fourteenth aspect of the present invention, there is provided the signal analyzing apparatus according to the eighth aspect, wherein

the exponent-mantissa separator comprises:

a decider (211) which receives the phase-detected data output from the adding unit of the IF detecting unit, discriminates a most significant bit of the received phase-detected data in when receiving by using a logical circuit (211a, 211b), and outputs a discrimination result;

a mantissa selector (212) which selects data of a plurality of bits including data of a predetermined number of lower bits from the discrimination result of the most significant bit output from the decider and outputs the data as mantissa data expressing the mantissa part based on plurality of selected bit data; and

an exponent determiner (213) which converts the most significant bit into identifiable identification data based on the discrimination result of the most significant bit output from the decider and outputs the identification data as exponent data expressing the exponent part.

In order to achieve the above object, according to a fifteenth aspect of the present invention, there is provided a signal measuring method comprising the steps of:

preparing a data converting unit (100), an exponent-mantissa separator (210), a mantissa calculating table (220), an exponent output unit (230), and an adder (240);

causing the data converting unit to convert an input signal into digital data having a predetermined number of bits at clocks having a predetermined cycle ts and to perform squared detection of the digital data to output phase-detected data;

causing the exponent-mantissa separator to receive the phase-detected data and to separate the phase-detected data into mantissa data expressing a mantissa part of the phase-detected data and exponent data expressing an exponent part of the phase-detected data to output the mantissa data and the exponent data;

outputting an output logarithm corresponding to the mantissa data stored in advance from the mantissa calculating table to be accessed by the mantissa data;

causing the exponent output unit to output a logarithm corresponding to the exponent data based on the exponent data output from the exponent-mantissa separator; and

causing the adder to, in order to obtain an output logarithm corresponding to the amplitude of the input signal, add the logarithm corresponding to the mantissa data to the logarithm corresponding to the exponent data and output an output logarithm corresponding to the phase-detected data.

In order to achieve the above object, according to a sixteenth aspect of the present invention, there is provided the signal measuring method according to the fifteenth aspect, wherein the exponent output unit comprises:

an exponent calculating table (230) which is accessed by the exponent data output from the exponent-mantissa separator and which outputs a logarithm corresponding to the exponent data stored in advance.

In order to achieve the above object, according to a seventeenth aspect of the present invention, there is provided the signal measuring method according to the fifteenth aspect, wherein the exponent-mantissa separator comprises:

a decider (211) which receives the phase-detected data output from the data converting unit, discriminates a most significant bit of the phase-detected data in when receiving by using a logical circuit (211a, 211b), and outputs a discrimination result;

a mantissa selector (212) which selects data of a plurality of bits including data of a predetermined number of lower bits from the discrimination result of the most significant bit output from the decider and outputs the data as mantissa data expressing the mantissa part based on the plurality of selected bit data; and

an exponent determiner (213) which converts the most significant bit into identifiable identification data based on the discrimination result of the most significant bit output from the decider and outputs the identification data as exponent data expressing the exponent part.

In order to achieve the above object, according to an eighteenth aspect of the present invention, there is provided the signal measuring method according to the fifteenth aspect, further comprising the steps of:

preparing an interpolating unit (500); and

causing the interpolating unit to receive the clocks having the predetermined cycle ts, interpolate the phase-detected data output from the data converting unit at an interval of 1/N in the predetermined cycle ts, and transmit an interpolated value to the exponent-mantissa separator.

In order to achieve the above object, according to a nineteenth aspect of the present invention, there is provided the signal measuring method according to the eighteenth aspect, wherein the interpolating unit is configured to designate phase-detected data at a center (mts) of a range to be interpolated by the phase-detected data output at intervals of 1/N in the predetermined cycle ts, generate an extraction signal (mts$\pm$p, p is an integer ranging from 0 to N/2) having a cycle ts/N in the range to be interpolated, weight the phase-detected data $\{\rho(mts)\}$ at the center of the range to be interpolated and nearest phase-detected data $\{\rho((m-1)ts), \rho((m+1)ts)\}$ corresponding to width ($\pm$p) of a space between the extraction signal and the center in the range to be interpolated, and generate the interpolated value every extraction signal based on a weighted values.

In order to achieve the above object, according to a twentieth aspect of the present invention, there is provided the signal measuring method according to the fifteenth aspect, wherein the data converting unit comprises:

an analog/digital (A/D) converting unit (110) which converts the input signal into digital data having the predetermined number of bits with clocks having the predetermined cycle ts;

a quadrature detecting unit (121) which performs a mixing operation to each component obtained by branching an output from the A/D converting unit into two components independently of two local signals having phases different from each other by 90° and each having a predetermined frequency and outputs two quadrature components having phases orthogonalized at a frequency corresponding to a difference between the frequency of the input signal and the predetermined frequency;

a resolution bandwidth (RBW) filter unit (122) which performs predetermined bandwidth limitation to the two quadrature components output from the quadrature detecting unit and outputs two bandwidth limitation resultant quadrature components;

a square detecting unit (123) which performs square detection to the two quadrature components output from the RBW filter unit and outputs two square detection resultant quadrature components; and

an adding unit (124) which adds the two square detection quadrature components output from the square detecting unit.

In order to achieve the above object, according to a twenty-first aspect of the present invention, there is provided the signal measuring method according to the fifteenth aspect, further comprising the steps of:

preparing an amplitude probability measuring unit (300) comprising a memory (310), a data converter (320), a frequency extracting unit (330), and an amplitude probability calculating unit (340);

outputting data corresponding to the output logarithm stored in advance to the address from the memory which is accessed by using the output logarithm output from the adder as an address value (k);

causing the data converter to receive data $\{G^{n-1}(k) : n$ is the number of times of access up to the previous access$\}$ at the address output from the memory, convert the data into data $\{G^n(k)\}$ including information expressing the number of times of the latest access, and store the data at identical address in the memory;

causing the frequency extracting unit to receive the latest data $G^n(k)$ output from the memory and convert the data into the number of times $\{n(k)\}$ of access performed to addresses by the output logarithm to output the number of times; and

causing the amplitude probability calculating unit to calculate an amplitude probability based on the number of times $\{n(k)\}$ of access performed by the output logarithm and output the amplitude probability.

In order to achieve the above object, according to a twenty-second aspect of the present invention, there is provided a signal analyzing method comprising the steps of:

preparing a high-frequency (RF) unit (900), an analog/digital (A/D) converting unit (110), an IF detecting unit (120), a log converting unit (200), a display unit (600), and a display control unit (400);

causing the RF unit to sweep a desired frequency bandwidth to an input high-frequency (RF) signal, and thereby to convert the input RF signal selectively received into a predetermined intermediate-frequency (IF) signal and output the IF signal;

causing the A/D converting unit to analog/digital-convert the IF signal with the clocks having the predetermined cycle ts and output digital data having a predetermined number of bits;

preparing the IF detecting unit (120) comprising a quadrature detecting unit (121), a resolution bandwidth (RBW) filter unit (122), a square detecting unit (123), and an adding unit (124);

causing the quadrature detecting unit to perform a mixing operation to each component obtained by branching an output from the A/D converting unit into two components independently of two local signals having phases different from each other by 90° and each having a predetermined frequency and output two quadrature components having phases orthogonalized at a frequency corresponding to a difference between the frequency of the input signal and the predetermined frequency;

causing the RBW filter unit to perform predetermined bandwidth limitation to the two quadrature components and output two bandwidth limitation resultant quadrature components;

causing the square detecting unit to perform square detection to the two quadrature components subjected to the bandwidth limitation and output two square detection resultant quadrature components;

causing the adding unit to add the two square detection resultant quadrature components output from the square detecting unit and output phase-detected data;

preparing the log converting unit (200) comprising an exponent-mantissa separator (210), a mantissa calculating table (220), an exponent output unit (230), and an adder (240);

causing the exponent-mantissa separator to receive the phase-detected data and separate the phase-detected data into mantissa data expressing a mantissa part of the phase-detected data and exponent data expressing an exponent part of the data and output the mantissa data and the exponent data;

outputting a logarithm corresponding to the mantissa data stored in advance from the mantissa calculating table which is accessed by the mantissa data;

causing the exponent output unit to output a logarithm corresponding to the exponent data based on the exponent data;

causing the adder to add the logarithm corresponding to the mantissa data output from the mantissa calculating table to the logarithm corresponding to the exponent data output from the exponent output unit and output an output logarithm corresponding to the phase-detected data; and

causing the display control unit to display the output logarithm corresponding to the phase-detected data on the display unit.

In order to achieve the above object, according to a twenty-third aspect of the present invention, there is provided the signal analyzing method according to the twenty-second aspect, wherein the exponent output unit comprises:

an exponent calculating table (230) which is accessed by the exponent data output from the exponent-mantissa separator and which outputs a logarithm corresponding to the exponent data stored in advance.

In order to achieve the above object, according to a twenty-fourth aspect of the present invention, there is provided the signal analyzing method according to the twenty-second aspect, further comprising the steps of:

preparing an amplitude probability measuring unit (300) comprising a memory (310), a data converter (320), a frequency extracting unit (330), and an amplitude probability calculating unit (340);

outputting data corresponding to the output logarithm stored in advance to the address from the memory which is accessed by using the output logarithm as an address value (k);

causing the data converter to receive data $\{G^{n-1}(k) :$ n is the number of times of access up to the previous access$\}$ at the address output from the memory, convert the data into data $\{G^n(k)\}$ including information expressing the number of times of the latest access, and store the data at identical address in the memory;

causing the frequency extracting unit to receive the latest data $G^n(k)$ output from the memory, convert the data into the number of times $\{n(k)\}$ of access performed to addresses by the output logarithm, and output the number of times; and

causing the amplitude probability calculating unit to calculate an amplitude probability based on the output of the number of times $\{n(k)\}$ of access performed by the output logarithm.

In order to achieve the above object, according to a twenty-fifth aspect of the present invention, there is provided the signal analyzing method according to the twenty-fourth aspect, further comprising the steps of:

preparing an interpolating unit (500);

causing the interpolating unit to receive the clocks having the predetermined cycle ts, interpolate the phase-detected data output from the data converting unit at an interval of 1/N in the predetermined cycle ts, and transmit an interpolated value to the exponent-mantissa separator; and

causing the display control unit to selectively display the logarithm corresponding to the phase-detected data or the amplitude probability such that the frequencies in the desired frequency bandwidth on the abscissa are displayed by any of frequencies corresponding to an interval of the predetermined cycle ts and frequencies corresponding to an interval of a cycle ts/N.

In order to achieve the above object, according to a twenty-sixth aspect of the present invention, there is provided the signal analyzing method according to the twenty-fifth aspect, wherein the display control unit is configured to selectively display the logarithm corresponding to the phase-detected data or the amplitude probability such that the frequencies in the desired frequency bandwidth on the abscissa are displayed by frequencies corresponding to an interval of the predetermined cycle ts and some of the frequencies are magnified and displayed by the frequencies corresponding to the interval of the cycle ts/N.

In order to achieve the above object, according to a twenty-seventh aspect of the present invention, there is provided the signal analyzing method according to the twenty-fifth aspect, wherein the interpolating unit is configured to designate phase-detected data at a center (mts) of a range to be interpolated by the phase-detected data output at intervals of 1/N in the predetermined cycle ts, generate an extraction signal (mts$\pm$p, p is an integer ranging from 0 to N/2) having a cycle ts/N in the range to be interpolated, weight the phase-detected data $\{\rho(mts)\}$ at the center of the range to be interpolated and nearest phase-detected data $\{\rho((m-1)ts), \rho((m+1)ts)\}$ corresponding to width ($\pm$p) of a space between the extraction signal and the center in the range to be interpolated, and generate the interpolated value every extraction signal based on weighted values.

In order to achieve the above object, according to a twenty-eighth aspect of the present invention, there is provided the signal analyzing method according to the twenty-second aspect, wherein
the exponent-mantissa separator comprises:

a decider (211) which receives the phase-detected data output from the adding unit of the IF detecting unit, discriminates a most significant bit of the received phase-detected data by a logical circuit (211a, 211b), and outputs a discrimination result;

a mantissa selector (212) which selects data of a plurality of bits including data of a predetermined number of lower bits from the discrimination result of the most significant bit output from the decider and outputs the data as mantissa data expressing the mantissa part based on plurality of selected bit data; and

an exponent determiner (213) which converts the most significant bit into identifiable identification data based on the discrimination result of the most significant bit output from the decider and outputs the identification data as exponent data expressing the exponent part.

According to the signal measuring/analyzing apparatuses and the signal measuring/analyzing methods of the first to twenty-eighth aspects of the present invention configured as described above, the amplitude of an input signal can be rapidly measured by a hardware configuration such as a logical circuit at a preferably log characteristic with a minimum memory capacity, and data can be calculated while interpolating digital data set in a sampling interval. For this reason, the present invention has the advantages that omissions in measurement caused by sampling intervals can be reduced.

This summary of the invention does not necessarily describe all necessary features so that the invention may also be a sub-combination of these described features.

The invention can be more fully understood from the following detailed description when taken in conjunction with the accompanying drawings, in which:

FIG. 1 is a block diagram shown to explain an overall functional configuration of a signal measuring apparatus according to the present invention;

FIG. 2 is a block diagram shown to explain a configuration of a log converting unit 200 for use in the signal measuring apparatus in FIG. 1;

FIG. 3 is a block diagram shown to explain a configuration of a decider 211 in FIG. 2;

FIG. 4A is a block diagram shown to explain a 2-bit deciding circuit as a logical circuit constituting the decider 211 in FIG. 3;

FIG. 4B is a diagram showing a logical value table of the 2-bit deciding circuit in FIG. 4A;

FIG. 4C is a block diagram shown to explain a 4-bit deciding circuit as a configuration of the logical circuit constituting the decider 211 in FIG. 3;

FIG. 5 is a block diagram shown to explain a configuration related to interpolation of data as a main configuration of a signal measuring apparatus according to a first embodiment of the present invention;

FIGS. 6A, 6B, and 6C are diagrams for explaining modes of data interpolation performed by the signal measuring apparatus in FIG. 5;

FIG. 7 is a block diagram shown to explain a configuration of an interpolating unit 500 for use in the signal measuring apparatus in FIG. 5;

FIG. 8A is a block diagram of a main part shown to explain an application of the first embodiment;

FIG. 8B is an amplitude probability distribution (APD) characteristic diagram shown to explain an application of the first embodiment;

FIG. 9 is a block diagram for explaining a configuration of an amplitude probability measuring (APD) unit 300 in FIG. 1;

FIG. 10 is a block diagram shown to explain an overall functional configuration of a signal measuring apparatus according to a second embodiment of the present invention;

FIG. 11 is a graph for explaining a display according to the second embodiment of the present invention;

FIG. 12 is a graph showing an output (display) from an amplitude probability measuring (APD) unit 300 according to the second embodiment of the present invention;

FIG. 13 is a table showing logical values obtained by the decider 211 in FIG. 2; and

FIG. 14 is a block diagram showing a configuration of another example of the log converting unit 200 in FIG. 1.

Reference will now be made in detail to the embodiments of the invention as illustrated in the accompanying drawings, in which like reference numerals designate like or corresponding parts.

Embodiments of a signal measuring/analyzing apparatus and a signal measuring/analyzing method according to the present invention will be described below with reference to the accompanying drawings.

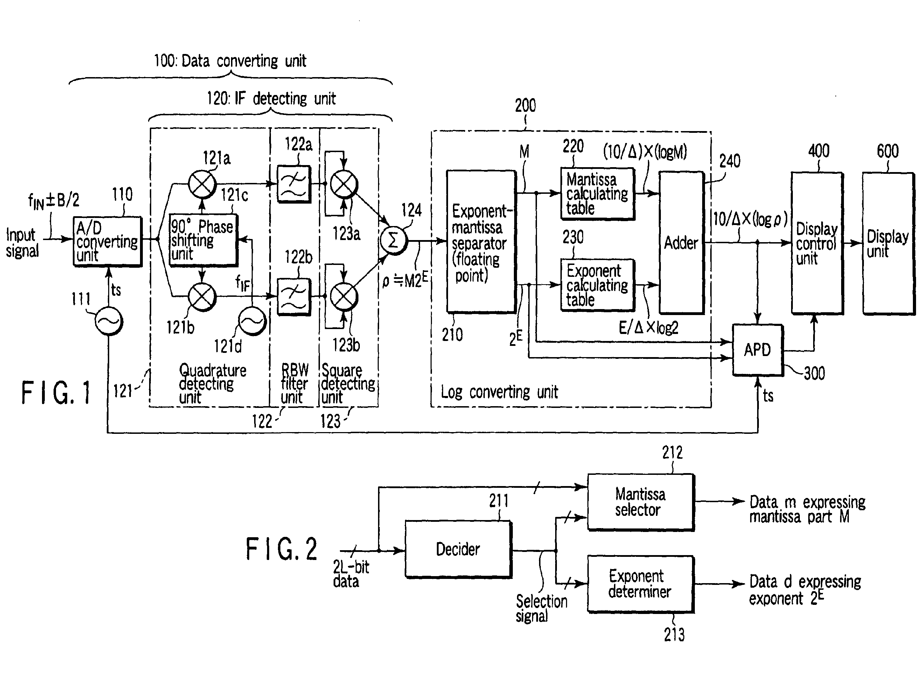

A signal measuring apparatus according to the present invention, basically, as shown in FIG. 1, has a data converting unit 100, an exponent-mantissa separator 210, a mantissa calculating table 220, an exponent output unit 230, and an adder 240. The data converting unit 100 converts an input signal into digital data having a predetermined number of bits with clocks having a predetermined cycle ts, and performs squared detection of the digital data to output the resultant data as phase-detected data. The exponent-mantissa separator 210 receives the phase-detected data output from the data converting unit 100, and separates the phase-detected data into mantissa data expressing a mantissa part of the phase-detected data and exponent data expressing an exponent part of the phase-detected data to output the mantissa data and the exponent data. The mantissa calculating table 220 is accessed by the mantissa data output from the exponent-mantissa separator 210 and outputs a logarithm corresponding to the mantissa data stored in advance. The exponent output unit 230 outputs a logarithm corresponding to the exponent data based on the exponent data output from the exponent-mantissa separator 210. In order to obtain an output logarithm corresponding to the amplitude of the input signal, the adder 240 adds the logarithm corresponding to the mantissa data output from the mantissa calculating table 220 to the logarithm corresponding to the exponent data output from the exponent output unit 230, and outputs an output logarithm corresponding the phase-detected data.

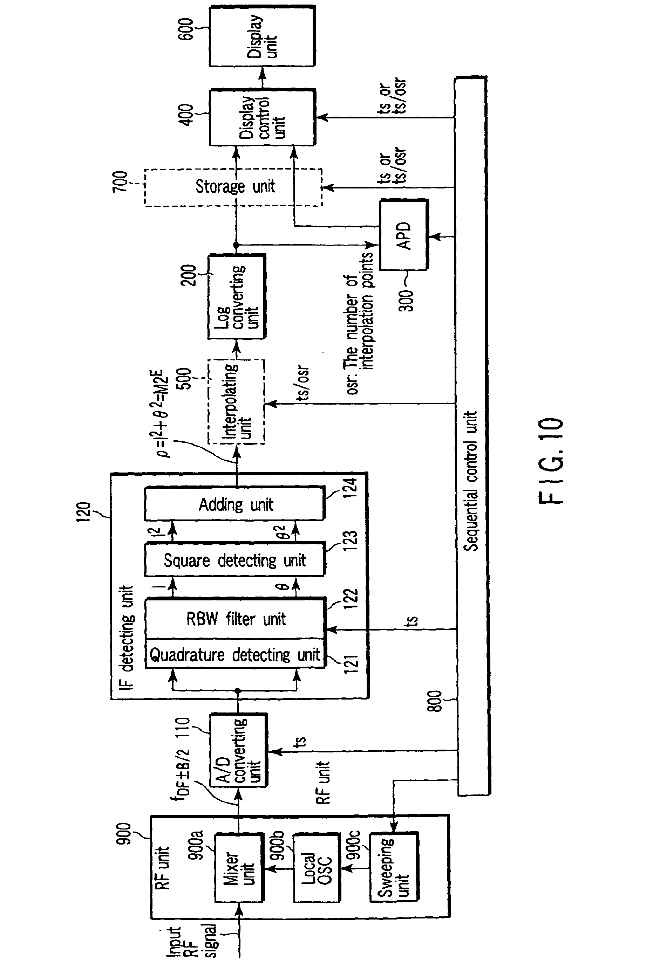

A signal analyzing apparatus according to the present invention, basically, as shown in FIG. 10, has an RF unit 900, an analog/digital (A/D) converting unit 110, an IF detecting unit 120, a log converting unit 200, and a display control unit 400. The RF unit 900 sweeps a desired frequency bandwidth to an input high-frequency (RF) signal, and thereby converts the input RF signal selectively received into a predetermined intermediate-frequency (IF) signal and outputs the IF signal. The A/D converting unit 110 analog/digital-converts the IF signal output from the RF unit 900 with the clocks having the predetermined cycle ts, and outputs digital data having a predetermined number of bits. The display control unit 400 displays a logarithm corresponding to the phase-detected data output from the log converting unit on a display unit 600.

The IF detecting unit 120 has a quadrature detecting unit 121, a resolution bandwidth (RBW) filter unit 122, a square detecting unit 123, and an adding unit 124. The quadrature detecting unit 121 performs a mixing operation to each component obtained by branching the digital data output from the A/D converting unit into two components independently of two local signals having phases different from each other by 90° and each having a predetermined frequency, and outputs two quadrature components having phases orthogonalized at a frequency corresponding to a difference between the frequency of the input RF signal and the predetermined frequency. The RBW filter unit 122 performs predetermined bandwidth limitation to the two quadrature components output from the quadrature detecting unit 121, and outputs the two bandwidth limitation resultant quadrature components. The square detecting unit 123 performs square detection to the two bandwidth limitation resultant quadrature components output from the resolution bandwidth (RBW) filter unit 122, and outputs the square detection resultant quadrature components. The adding unit 124 adds the two square detection resultant quadrature components output from the square detecting unit 123, and outputs phase-detected data.

The log converting unit 200 has an exponent-mantissa separator 210, a mantissa calculating table 220, an exponent output unit 230, and an adder 240. The exponent-mantissa separator 210 receives the phase-detected data output from the adding unit 124 of the IF detecting unit 120, and separates the phase-detected data into mantissa data expressing a mantissa part of the phase-detected data and exponent data expressing an exponent part of the data to output the mantissa data and the exponent data. The mantissa calculating table 220 is accessed by the mantissa data output from the exponent-mantissa separator 210 and outputs a logarithm corresponding to the mantissa data stored in advance. The exponent output unit 230 outputs a logarithm corresponding to the exponent data based on the exponent data output from the exponent-mantissa separator 210. The adder 240 adds the logarithm corresponding to the mantissa data output from the mantissa calculating table 220 to the logarithm corresponding to the exponent data output from the exponent output unit 230, and outputs a logarithm depending on the phase-detected data.

A signal measuring method according to the present invention, basically, as shown in FIG. 1, has: a step of preparing a data converting unit 100, an exponent-mantissa separator 210, a mantissa calculating table 220, an exponent output unit 230, and an adder 240; a step of causing the data converting unit 100 to convert an input signal into digital data having a predetermined number of bits at clocks having in a predetermined cycle ts and to perform squared detection of the digital data to output the resultant data as phase-detected data; a step of causing the exponent-mantissa separator 210 to receive the phase-detected data and to separate the phase-detected data into mantissa data expressing a mantissa part of the phase-detected data and exponent data expressing an exponent part of the phase-detected data to output the mantissa data and the exponent data; a step of outputting a logarithm corresponding to the mantissa data stored in advance from the mantissa calculating table 220 to be accessed by the mantissa data; a step of causing the exponent output unit 230 to output a logarithm corresponding to the exponent data based on the exponent data output from the exponent-mantissa separator 210; and a step of causing the adder 240, in order to obtain an output logarithm corresponding to the amplitude of the input signal, to add the logarithm corresponding to the mantissa data to the logarithm corresponding to the exponent data and to output an output logarithm corresponding to the phase-detected data.

A signal analyzing method according to the present invention, basically, as shown in FIG. 10, has: a step of preparing an RF unit 900, an analog/digital (A/D) converting unit 110, an IF detecting unit 120, a log converting unit 200, a display unit 600, and a display control unit 400; a step of causing the RF unit 900 to sweep a desired frequency bandwidth to an input high-frequency (RF) signal and thereby to convert the input RF signal selectively received into a predetermined intermediate-frequency (IF) signal and output the IF signal; a step of causing the A/D converting unit 110 to analog/digital-convert the IF signal with the clocks having the predetermined cycle ts and to output digital data having a predetermined number of bits; a step of preparing the IF detecting unit 120 including a quadrature detecting unit 121, a resolution bandwidth (RBW) filter unit 122, a square detecting unit 123, and an adding unit 124; a step of causing the quadrature detecting unit 121 to perform a mixing operation of each component obtained by branching the digital data into two components independently of two local signals having phases different from each other by 90° and having different predetermined frequencies and to output two quadrature components having phases orthogonalized at a frequency corresponding to a difference between the frequency of the input RF signal and the predetermined frequency; a step of causing the RBW filter unit 122 to perform predetermined bandwidth limitation to the two quadrature components and to output the resultant quadrature components; a step of causing the square detecting unit 123 to perform square detection to the two quadrature components subjected to the bandwidth limitation and to output the resultant quadrature components; a step of causing the adding unit 124 to add the two quadrature components output from square detecting unit and to output the additional value as phase-detected data; a step of preparing the log converting unit 200 including an exponent-mantissa separator 210, a mantissa calculating table 220, an exponent output unit 230, and an adder 240; a step of causing the exponent-mantissa separator 210 to receive the phase-detected data and to separate the phase-detected data into mantissa data expressing a mantissa part of the phase-detected data and exponent data expressing an exponent part of the data to output the mantissa data and the exponent data; a step of outputting a logarithm corresponding to the mantissa data stored in advance from the mantissa calculating table 220 to be accessed by the mantissa data; a step of causing the exponent output unit 230 to output a logarithm corresponding to the exponent data based on the exponent data; a step of causing the adder 240 to add the logarithm corresponding to the mantissa data output from the mantissa calculating table 220 to the logarithm corresponding to the exponent data output from the exponent output unit 230 and to output an output logarithm corresponding to the phase-detected data; and a step of causing the display control unit 400 to display the output logarithm corresponding to the phase-detected data on the display unit 600.

With reference to FIG. 1, configurations and operations will be described below in the order of operations from an input side to an output side.

In FIG. 1, a data converting unit 100 is constituted by an A/D converting unit 110 and an IF detecting unit 120.

The A/D converting unit 110 receives an input signal $f_{IN} \pm B/2$ (where $\pm B/2$ is a frequency band), performs sampling at clocks generated by a clock generators 111 in a predetermined cycle ts (frequency fs, for example, 100 MHz) to convert the sampled signal into digital data having a predetermined number of bits, for example, L (= 14) bits.

The two branched components of the digital data are transmitted to one inputs of mixers 121a and 121b constituting the IF detecting unit 120, respectively.

The IF detecting unit 120 is constituted by, in addition to the mixers 121a and 121b, a quadrature detecting unit 121 including a frequency generating unit 121d and a 90° phase shifter, an RBW filter unit 122, a square detecting unit 123, and an adder 124 to perform digital processing.

In the quadrature detecting unit 121, a digitized input signal $f_{IN}$ is orthogonally detected to obtain two low-frequency signals having quadrature phases.

The frequency generating unit 121d generates a local signal $f_{IF}$ which is a signal having a predetermined frequency which is almost equal to that of the input signal.

The 90° phase shifter 121 having received the local signal $f_{IF}$ generates two local signals $f_{IF}$ having quadrature phases, and transmits the two local signals $f_{IF}$ to the other inputs of the mixers 121a and 121b, respectively.

In this manner, from the mixers 121a and 121b, $I \propto \sin 2\pi fb$ and $Q \propto \cos 2\pi fb$ (where fb = $f_{IN}$ - $f_{IF}$ and a frequency band is B/2) are output.

The two quadrature signals from the mixers 121a and 121b are subjected to bandwidth limitation with bandwidths (RBW) required for respective resolutions of the two quadrature signals by low-pass filters 122a and 122b of the RBW filter unit 122, so that only a necessary signal is extracted.

The low-pass filters 122a and 122b are constituted by digital filters operated in a clock cycle ts. The clock cycle is made variable to make it possible to vary a resolution bandwidth (RBW).

Two outputs extracted by the low-pass filters 122a and 122b of the RBW filter unit 122 are subjected to square detection by two square detecting units 123a and 123b of the square detecting unit 123. The two outputs subjected to square detection are output.

The adder 124 adds the square-detected outputs from the two square detecting units 123a and 123b to each other, thereby outputting an additional signal given by $\rho(t) = I^2 + Q^2$, i.e., consequently, 2L-bit digital data expressing a level (power) value of the input signal $f_{IN}$ to a log converting unit 200.

The log converting unit 200 is equipped with an exponent-mantissa separator 210, a mantissa calculating table 220, an exponent calculating table 230, and an adder 240 which are constituted by hardware configurations such as digital circuits and memories, respectively.

The configuration and operation of the log converting unit 200 will be briefly described first, and the details thereof will be described later.

Digital data input from the adder 124 is 2L-bit data and is approximately expressed by, for example, $p = M2^E$ and $E = 2L - 1$.

The exponent-mantissa separator 210 separates the 2L-bit data input from the adder 124 into data m expressing a mantissa part M and data d expressing an exponent part $2^E$ by using a logical circuit (to be described later).

The mantissa calculating table 220 is constituted by a memory serving as a look-up table to store a logarithm corresponding to the mantissa part M in relation to a value of the data m expressing the mantissa part M in advance. An address corresponding to the value of the data m is accessed by the exponent-mantissa separator 210, so that a logarithm $10/\Delta x \log M$ ($1/\Delta$ is a coefficient) corresponding to the data m is output.

Similarly, the exponent calculating table 230 is constituted by a memory serving as a look-up table to store a logarithm corresponding to the exponent part $2^E$ in relation to data d expressing the exponent part $2^E$ in advance. An address corresponding to the value of the data d is accessed by the exponent-mantissa separator 210, so that a logarithm $E/\Delta x \log 2$ (any logarithm is a common logarithm) corresponding to the data d is output.

The adder 240 outputs a logarithm $10/\Delta x \log \rho$ obtained by adding the logarithm $10/\Delta x \log M$ of the mantissa part M output from the mantissa calculating table 220 to the logarithm $E/\Delta x \log 2$ of the exponent part $2^E$ output from the exponent calculating table 230.

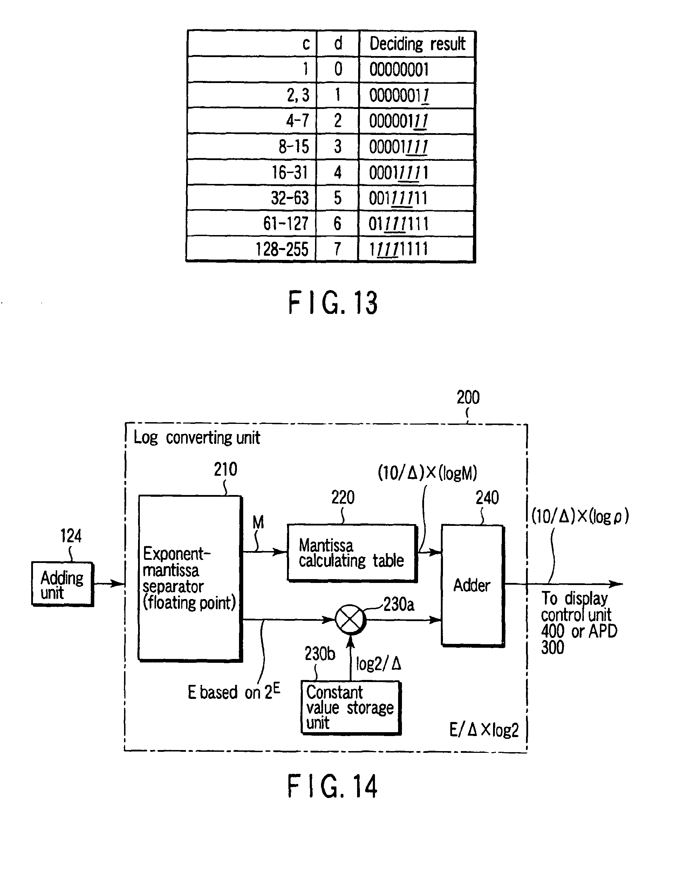

As shown in FIG. 14, by a multiplexer 230a used in place of the exponent calculating table 230 in FIG. 1, a value "E" (exponent) serving as the data d expressing the exponent part $2^E$ may be received from the exponent-mantissa separator 210 and multiplied by a constant value $\log 2/\Delta$ read from a constant value storage unit 230b to output $E/\Delta x \log 2$.

The exponent calculating table 230, the multiplexer 230a, and the constant value storage unit 230b constitute exponent output units according to the present invention, respectively.

A logarithm $10/\Delta x \log \rho$ output from the adder 240 is displayed on the display unit 600 in units of decibels by the display control unit 400.

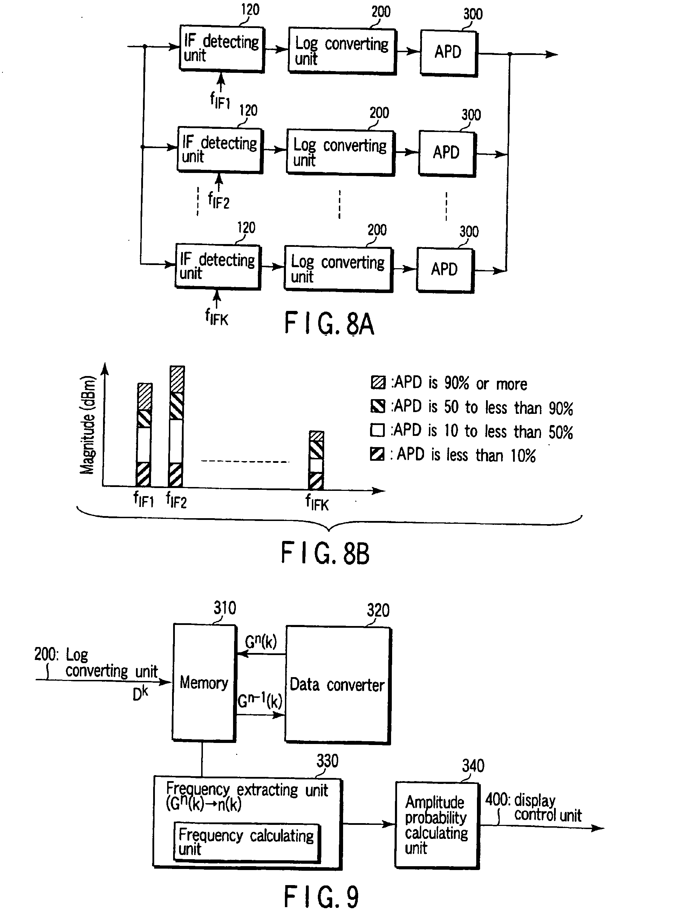

An amplitude probability (distribution) measuring unit (APD) 300 is a measuring unit which measures an amplitude probability (distribution) from the logarithm $10/\Delta x \log \rho$. As an example, the schematic configuration of the measuring unit is shown in FIG. 9.

In FIG. 9, the input data $10/\Delta x \log \rho$ is simply represented by D. Assuming that the value corresponds to an address k in a memory 310, data is expressed by Dk.

When the memory 310 is accessed by data Dk, a data converter 320 receives data $G^{n-1}(k)$ stored at an address k ($G^{n-1}(k)$ is data representing the number of times of access to the address k up to the previous access) and converts the data $G^{n-1}(k)$ into data $G^n(k)$ to restore the data $G^n(k)$ at the address k (update and record).

Every predetermined period, a frequency extracting unit 330 reads the data $G^n(k)$ from the memory 310 and extracts the number of times n(k) of access to the address k.

Since the address k represents a size of a level (since an output in log conversion, the size is expressed in units of decibels), the reference symbol n(k) is the number of times of generation of an input signal having the size (amplitude) in a predetermined period of time.

An amplitude probability calculating unit 340 observes the number of times of generation every predetermined period of time to calculate observation results as hour rates.

The APD 300 may calculates an amplitude probability (distribution) by receiving an output from the exponent-mantissa separator 210 (dotted line in FIG. 1) without an output from the adder 240 in FIG. 1.

The operation itself of the APD 300 is the same as described above. However, the number of bits of data to be processed when the output from the exponent-mantissa separator 210 is received is made smaller than the number of bits of data to be processed when the output from the adder 240 is received. For this reason, the APD 300 can be simply constructed on a scale.

With respect to the APD (amplitude probability measuring unit), more particular, a technique related to SPECTRUM ANALYZER HAVING FUNCTION OF DISPLAYING AMPLITUDE PROBABILITY DISTRIBUTION EFFECTIVELY descried in the specification of USP No. 6,509,728 serving as Patent Document 5 can be used.

The data G can be generated by a minimum memory capacity (to be described later) based on data conversion performed by a plurality of counting circuits corresponding to a plurality of primitive polynomials described in Patent Document 5 (U.S.P. No. 6,509,728).

The display control unit 400 displays data output from the APD 300 on the display unit 600 in a predetermined format.

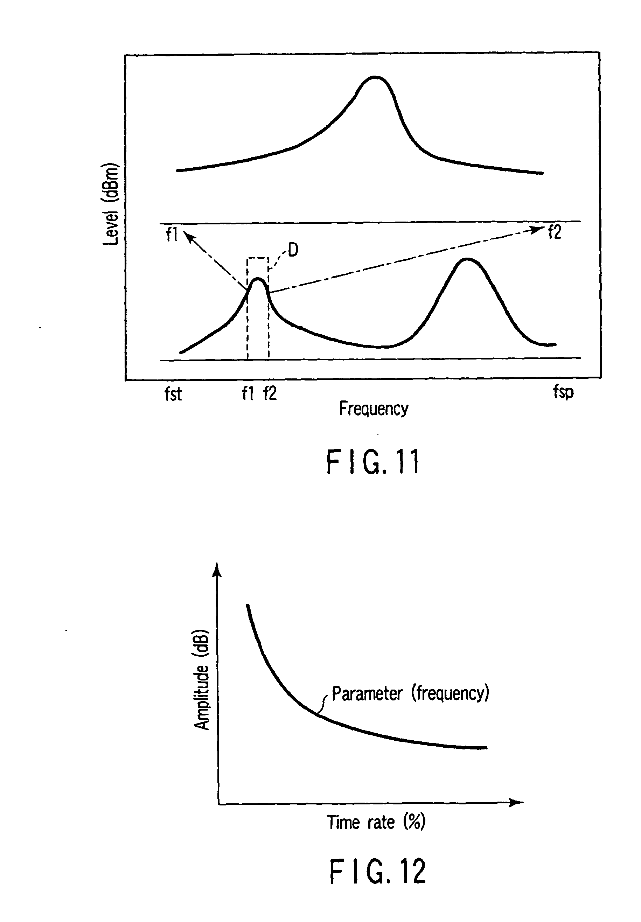

In FIG. 12 showing the display, the ordinate indicates the magnitude (decibel) of an interference wave which is an input signal, and the abscissa indicates an hour rate (%). On the coordinates, a probability distribution of the interference wave (electromagnetic wave) which is an input signal of a certain frequency component ($f_{IN}$).

However, when the APD 300 receives an output from the exponent-mantissa separator 210 to calculate an amplitude probability (distribution), the ordinate is linearly displayed.

(Application of First Embodiment)

In FIG. 8A showing a configuration serving as an application of the first embodiment, a plurality (k) of series connections each constituted by the IF detecting unit 120, the log converting unit 200, and the APD 300 in FIG. 1 are connected in parallel to each other, and the frequencies of frequency generating units 12d of the IF detecting units 120 are shifted bit by bit.

It is assumed that the resolution bandwidths of RBW units 112 of the IF detecting units 120 are given by $B_{RBW}$ and that the frequencies of the frequency generating units 12d are set at frequencies given by, for example, $f_{IF1}$, $f_{IF2} = f_{IF1} + 2B_{RBW}$, $f_{IF3} = f_{IF2} + 2B_{RBW}$, ..., which are different from each other by $2B_{RBW}$ each. In this case, an amplitude probability can be measured over an input frequency range of $f_{IF1}$ to $f_{IFk}$.

In FIG. 8B showing the display as the result, the ordinate indicates a signal level (dBm), the abscissa indicates a frequency, and the hour rates of APD are separately displayed in four areas of 10% or less, 10 to 50%, 50 to 90%, and 90% or more.

This display corresponds a kind of a display in which the hour rates are divisionally displayed depending on parameters in FIG. 12.

An output from the log converting unit 200 previous to the APD 300 in FIG. 8A is displayed, a spectrum over the input frequency range of $f_{IF1}$ to $f_{IFk}$ can be displayed.

In FIG. 8A, frequency analysis is performed by the plurality of IF detecting units 120 arranged in parallel to each other. However, the frequency analysis can also be realized by fast Fourier transformation.

Although not shown in FIG. 1, after a memory is arranged prior to the display control unit 400 to store an output from the log converting unit 200 or an output from the APD 300, the output may also be read, variously processed, and displayed.

Such a memory may be arranged prior to the log converting unit 200.

(Detailed Description of Log Converting unit 200)

The exponent-mantissa separator 210 of the log converting unit 200 separates input data p into a mantissa part M and an exponent part $2^E$ to generate data m and data d respectively expressing the mantissa part M and the exponent part $2^E$.

For this purpose, in this embodiment, the exponent-mantissa separator 210 converts input data into data in a floating-point format.

In general, 2L-bit binary-number data z is expressed in the following format (fixed point):

$$z_s = (Q0 \cdot 2^0) + (Q1 \cdot 2^1) + \ldots + (Q_{2L-1} \cdot 2^{2L-1})$$
$$= \Sigma 1 (Q_i \cdot 2^i)$$

where i is any one of values 0 to 2L-1 (expressing a digit place of a bit); and $Q_i$ is 0 or 1 (bit data expressing a place value).

The data d expressing the exponent part $2^E$ of binary-number data $z_s$ with respect to an actually input signal is an integer ranging from 0 to 2L-1 (2L bit), and a value which satisfies the following condition:

$$2^d \leq z_s < 2^{d+1},$$

and bit data Q in the data $z_s$ is "1" which is the most-significant place value.

When the binary-number data $z_s$ is expressed by the data d, the following condition is established:

$$z_s = 2^d + \Sigma 2 (Q_i \cdot 2^i)$$
$$= 2^d (1 + \Sigma 3 (Q_{d-i} \cdot 2^{-i}))$$

where $\Sigma_2$ is a sum of i (i = 0 to 2d-1); and $\Sigma_3$ is a sum of i (i = 0 to oo).

A significant digit used when the binary-number data $z_s$ is expressed in a floating-point format is set at 4 bits, i.e., up to 3 bits following "1" the most-significant digit, the binary-number data $z_s$ is expressed by the following equation:

$$z_S = 2^d[1 + m/2^3]$$

where m = $(Q_{d-1} \cdot 2^2) + (Q_{d-2} \cdot 2^1) + (Q_{d-3} \cdot 2^0)$.

More specifically, by floating-point conversion, the data p obtained by converting a floating-point-format data constituted by r-bit data m expressing the mantissa part M and g-bit data d expressing the exponent part $2^E$ is expressed by the following equation:

$$\rho = z_S = (1 + m/2^r)2^d.$$

When the data is compared with the data p = $M2^E$ of the original input signal, the data is expressed as follows:

M : $1 + m/2^r$
E : d

More specifically, the mantissa part M and the exponent part $2^E$ can be determined based on the data m and the data d.

In the above expression, as the bit rate r of the data m expressing the mantissa part M increases, accuracy is improved. However, in fact, since the data m may falls within an allowable error range, the bit rate is satisfactorily set at 8 bits (however, in this case, the explanation will be performed on the assumption that the bit rate r is set at 3 bits).

The exponent part d sufficiently has 5 bits (= g) when the exponent E has 2L = 32 bits and is expressed by a binary number.

In other words, this means that the data d is converted into a binary number which can discriminate 2L values.

As described above, in the exponent-mantissa separator 210, the data m expressing the mantissa part and the data d expressing the exponent part are separately output.

For this reason, the decider 211 decides the most-significant bit (digit) as shown in FIG. 2.

A mantissa selector 212 selects and outputs 3-bit data m following the most-significant lower digit from the data p, with the decision result of the decider 211 being as a selection signal.

An exponent determiner 213 generates 5-bit data d having the most-significant digit value decided by the decider 211.

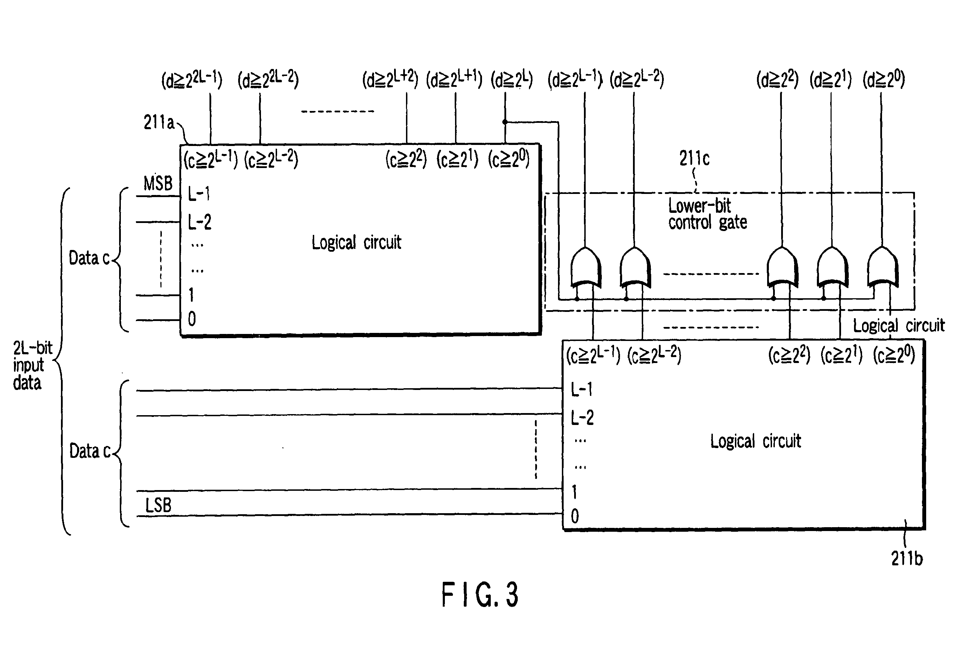

A concrete configuration of the decider 211 is shown in FIG. 3.

FIG. 3 shows a case where, if some digit has bit data "1" depending on input 2L-bit data p by an upperbit deciding logical circuit 211a, a lower-bit deciding logical circuit 211b, and a lower-bit control circuit 211c, bit data of digits following the digit is set at "1". As a result, the most-significant digit number is decided.

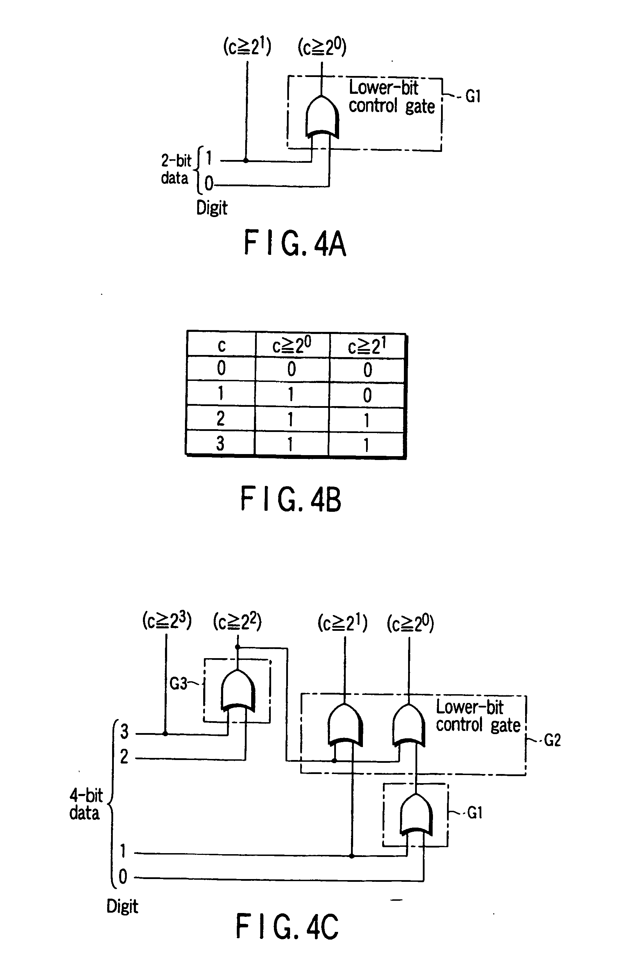

The principle in FIG. 3 will be described in advance with reference to FIGS. 4A, 4B, and 4C.

FIG. 4A is a 2-bit deciding circuit having a lower-bit control gate G1 constituted by an OR logical element, and a logical value table of the deciding circuit is shown in FIG. 4B.

FIG. 3 shows the following fact. That is, outputs from the logical circuits 211a and 211b (c ≥ $2^{L-1}$) to (c ≥ $2^0$), in this case, (c ≥ $2^3$) to (c ≥ $2^0$) are "1" when logical values in () are true, and the outputs are "0" when the logical values are false.

As is apparent from the logical values in FIG. 4B, the deciding circuit is designed such that, when the logical result (c ≥ $2^1$) is "1", a logical result (c ≥ $2^0$) must be "1" by the lower-bit control gate G1 in FIG. 4A.

In FIG. 4C, lower-bit control gates G2 and G3 are additionally connected to a 2-bit deciding circuit having the lower-bit control gate G1 in FIG. 4A in a laddery form to expand the 2-bit deciding circuit into a 4-bit deciding circuit.

More specifically, FIG. 4C shows that an H-bit deciding circuit and an H-bit deciding circuit are expanded by H OR logical elements to make it possible to constitute a 2H-bit deciding circuit.

The logical circuit in FIG. 3 constitutes two L-bit deciding circuits 211a and 211b by expanding the configuration in FIG. 4A like the configuration in FIG. 4C.

The logical circuit in FIG. 3 has the following configuration. That is, decision results of the deciding circuit 211b are further connected to one inputs of L OR logical elements constituting the lower-bit control gate 211c, and the other inputs of the L OR logical elements are commonly connected to each other and receive a least-significant deciding result of the logical circuit 211a.

In this manner, the logical circuit in FIG. 3 constitutes a deciding circuit which decides a digit of the 2L-bit data p as a result. A logical value table of the deciding results is shown in FIG. 13.

For descriptive convenience, FIG. 13 shows an example about 8-bit data. "1" on the left end of a row "1" of the deciding result denotes a most-significant digit place.

"1" of three digits underlined is a bit constituting a mantissa part and a bit (position) selected by the mantissa selector 212 (however, bit data at the bit is selected from the data p).

The exponent determiner 213 in FIG. 2 is to convert a logical value representing a most-significant digit place output from the decider 211 into 5-bit data.

For example, when the most significant digit is a result of $(c \geq 2^3) = 1$, the exponent "3" is converted into 5-bit data "00011". The data is output as data d expressing an exponent part.

As a concrete example of a method of converting the data expressing the exponent part, a binary tree multiplexer described in Patent Document 4 (Non-patent Documents 1 and 2) described above can be directly used. For this reason, an explanation of the method will be omitted.

The mantissa selector 212 selects 3-bit bit data following the most significant digit from the input data p and outputs the three bits as data m expressing the mantissa part.

As a concrete example of a method of selecting the data expressing the mantissa part, the binary tree multiplexer described in Patent Document 4 (Non-patent Documents 1 and 2) described above can be directly used. For this reason, an explanation of the method will be omitted.

(Simplification of Log Converting Unit 200).

In the log converting unit 200, data is converted into data in a floating-point format, and an exponent part and a mantissa part are separated from each other. The parts are input to two look-up tables (mantissa calculating table 220 and exponent calculating table 230) and converted into logarithms.

This contributes to simplification of the configuration of the log converting unit 200.

For example, when quadrature components I and Q in the IF detecting unit 120 are expressed by L = 16-bit-signed integer (integer which is $-2^{15}$ or more and $2^{15}-1$ or less), $p = I^2 + Q^2$ is a positive integer which is $2^{31}$ or less. For this reason, the value is expressed by a 32-bit positive integer (integer which is 0 or more and $2^{32}-1$ or less).

At this time, when the resolution of a logarithm is set at 16 bits, a memory of $2^{31}$ words is required.

As described above, for example, the data is converted into floating-point type 13-bit data constituted by a 5-bit exponent part and an 8-bit mantissa part to obtain the following equation:

$$\rho = M2^E, \quad M : \{0,1/\ldots 255\}, \quad E : \{0, 1/\ldots 31\}.$$

In this case, the value is expressed by:

$$10/\Delta \times Log\rho = (10/\Delta \cdot LogM) + (3.010299/\Delta \cdot E).$$

The values of the first and second terms of the righthand side are independently read from the look-up tables and added to each other, so that the log converting unit can be advantageously achieved by a memory of 256 + 32 = 285 words each of which is constituted by 16 bits.

This is very advantageous when a logical circuit to be used is constituted by an LSI.

When an error generated at this time is considered, it is understood that the error is expressed by the following equation with little trouble:

$$10Log(1 + 1/2^8) = 0.017dB$$

When the error should be reduced, the number of bits of a mantissa may be increased.

(First Embodiment)

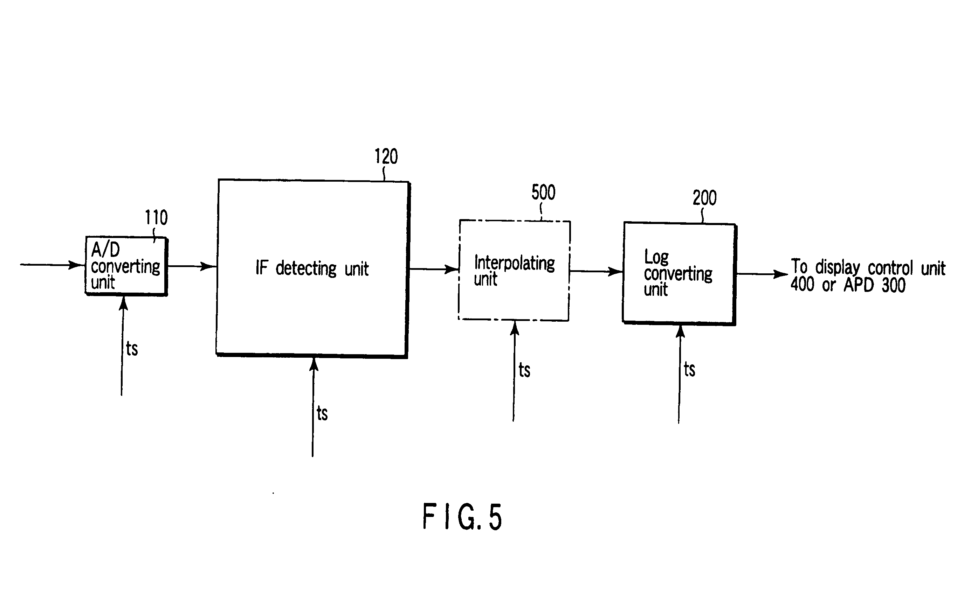

In the first embodiment, as shown in FIG. 5, an interpolating unit 500 is arranged between the IF detecting unit 120 and the log converting unit 200 described above.

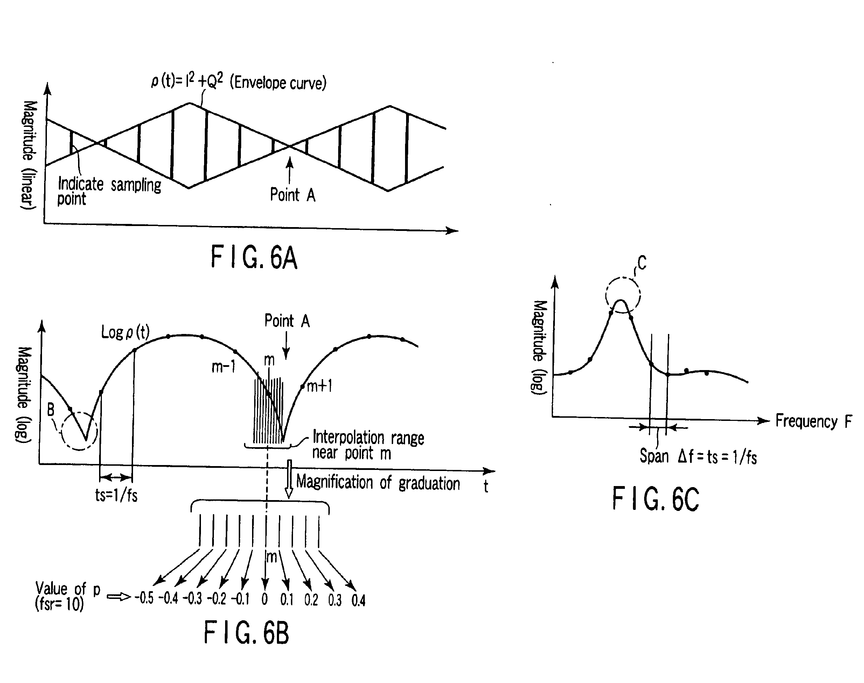

The necessity of the interpolating unit 500 will be described below with reference to FIGS. 6A, 6B, and 6C.

FIG. 6A shows a measurement data in a time domain. The ordinate indicates a magnitude (linear) of amplitude, and the abscissa indicates time.

A waveform shown in FIG. 6A is a waveform ($\rho(t) = I^2 + Q^2$) obtained by receiving a high-frequency input signal having a triangular waveform and subjected to AM modulation and detecting the high-frequency input signal by the IF detecting unit 120, and exhibits an envelope curve of an AM-modulated wave.

When the waveform shown in FIG. 6A is subjected to log conversion, a waveform shown in FIG. 6B is obtained (In FIG. 6B, the ordinate indicates a log.).

When an amplitude becomes very small as indicated by a point A in FIG. 6A, an extremum which is sharply small as indicated by a point A in FIG. 6B is exhibited.

However, in fact, digitization causes data to be set between points (positions of black points in the drawings) of sampling performed by the A/D converting unit 110 every clock ts. For this reason, as shown by a portion B in FIG. 6B, the data is not measured without interpolation.

The sampling intervals ts on the abscissa in FIGS. 6A, 6B, and 6C are roughly displayed to help someone understand.

FIG. 6C is an exemplary measurement performed when the first embodiment is applied to a spectrum analyzer (will be described later in detail). The abscissa indicates a frequency, and the ordinate indicates a level (displayed by dB).

Also in this case, when a peak point of a certain electric wave is set in a sampling interval ts as indicated by a portion C in FIG. 6c, a frequency at this point may not be measured.

The interpolating unit 500 is to interpolate data in the sampling interval ts as described above based on data at sampling points near the sampling interval to obtain the data in the sampling interval ts.

The interpolation, for example, is to interpolate a range between -0.5 (ts) to +0.4 (ts) centering around a sampling point m (ts) at sampling intervals each of which is 1/10 the sampling interval ts, i.e., 0.1ts intervals, as shown in FIG. 6B.

When the interpolation is performed with respect to the sampling points, data at 0.1ts intervals can be obtained.

In this case, the ts/10 intervals are described. However, in general, interpolation can be performed at ts/2N (N is an integer) intervals.

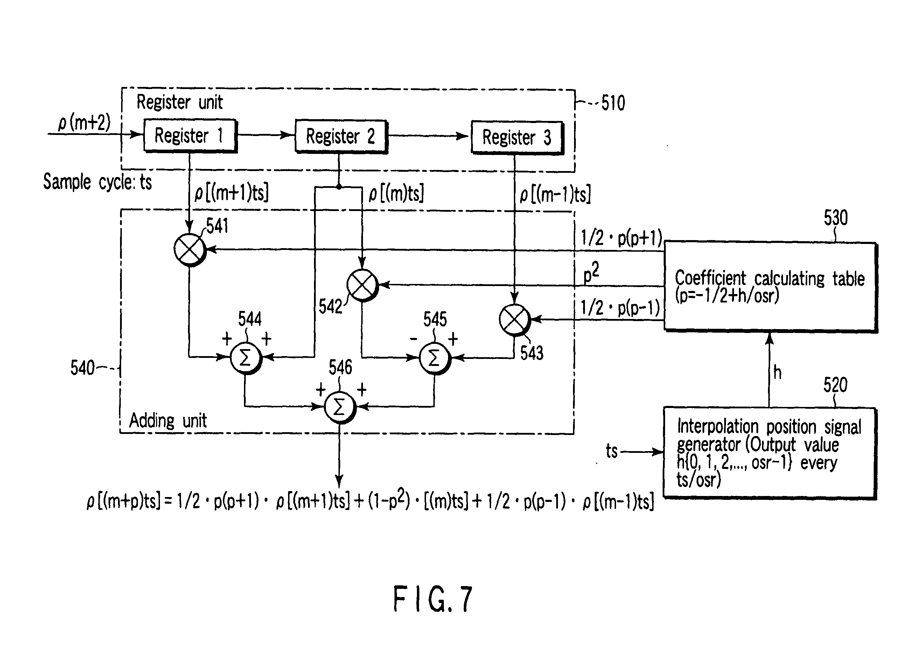

FIG. 7 shows a detailed circuit of the interpolating unit 500.

In a register unit 510 of the interpolating unit 500, data p[(m)ts] in the middle of an interpolation range to which interpolation is to be performed, data $\rho$[(m+1)ts] and $\rho$[(m-1)ts] which are closest thereto are temporarily stored in register 1, register 2, and register 3, respectively.

On the other hand, an interpolation position signal generator 520 generates interpolation timing signals h = 0, 1, 2, 3, ..., 9 at interpolation intervals expressed by ts/osr (osr: over sampling rate), for example, osr = 10, every 0.1ts.

A coefficient calculating table 530 outputs, as p = -1/2+h/osr, coefficients of 1/2·p(p+1) and $p^2$, and 1/2·p(p-1).

By an adding unit 540 constituted by multiplexers 541, 542 and 543 and adders 544, 545 and 546, the following data p[(m+p)ts] is output.

$$\rho[(m+p)ts]$$
$$= 1/2 \cdot p(p+1) \cdot \rho[(m+1)ts] + (1-p^2) \cdot [(m)ts]$$
$$+ 1/2 \cdot p(p-1) \cdot \rho[(m-1)ts]$$

When osr = 10 in the above equation, an interpolation interval is 0.1ts, an interpolation timing signal h = 5, and p = 0 is satisfied. As a result, p[(m+p)ts] = p[(m)ts] is satisfied.

More specifically, it is possible to acquire data p at interpolation points (see graduation points understandably enlarged) of -0.5(ts) to +0.4(ts) centered about a point m(ts) in FIG. 6B.

As a method of using the interpolating unit 500, the following method can also be used in addition to the above using method. That is, for example, although conventional measurement is performed at intervals ts, measurement is performed at 10ts intervals (clock of the A/D converting unit 110 is set at 10ts) to make it possible to obtain interpolated data at intervals ts.

In this case, a processing load of the RBW 122 constituted by a digital filter can be reduced.

As a matter of course, in this case, it must be satisfied that data to be interpolated continues at the 10ts intervals.

(Second Embodiment)

A second embodiment is an embodiment in which the log converting unit 200, the interpolating unit 500, and the APD 300 in the above description are applied to a signal analyzing apparatus, for example, a spectrum analyzer.

FIG. 10 is a block diagram showing a configuration of a spectrum analyzer applied as a signal analyzing apparatus according to the second embodiment.

In FIG. 10, parts indicated by the same reference numerals as in FIGS. 1 and 5 have the same functions in FIGS. 1 and 5.

Most of the contents of the first embodiments can be applied to the second embodiment.

In FIG. 10, a high-frequency (RF) unit 900 is a receiving unit which converts an input RF signal having a frequency $f_{RF}$ into a predetermined intermediate-frequency signal $f_{IN}$ while sweeping the input RF signal over a predetermined frequency range, thereby selectively receiving the input RF signal.

The sweeping unit 900c receives information representing a frequency range (this range is called a "frequency span") from an fst (start frequency) to an fsp (stop frequency) by a designation from a sequential control unit 800, and sweeps the oscillation frequency of a local signal oscillator (OSC) 900b from $(fst + f_{IN})$ to $(fsp + f_{IN})$ for sweeping time tspan.

A mixer unit 900a receives an input RF signal, mixes the input RF signal with a local signal from the local signal OSC 900b, and outputs the intermediate-frequency signal $f_{IN}$ to an A/D converting unit 110.

The A/D converting unit 110 outputs L = tspan/ts digital data at clock ts intervals per sweeping operation.

In this case, a frequency interval per cycle ts is given by (fst - fsp) /L (Hz).

The sequential control unit 800 receives a desired frequency span range (frequency span) to be measured and desired sweeping time tspan to sweep the frequency span from an operation unit (not shown) on a panel and determines a clock cycle ts or the like, so that operation timings of respective parts are controlled.

An output from the A/D converting unit 110 is limited in bandwidth to a resolution bandwidth by an IF detecting unit 120 and squared and then output.

The interpolating unit 500 outputs data obtained by interpolating and approximating a squared-detection waveform output from the IF detecting unit 120 at, for example, 0.1ts intervals (osr = 10).

In this case, data obtained at ts intervals are obtained as a matter of course.

By interpolated approximation, data having a fineness of (fst - fsp)/10L (Hz) in terms of a frequency interval can be obtained.

As the output from the interpolating unit 500, an amplitude (level) is log-converted by the log converting unit 200, and the log-converted amplitude is stored in a storage unit 700 at intervals of frequencies of (fst - fsp)/10L (Hz).

Data is read from the storage unit 700 and displayed on a display unit 600 as shown in, for example, FIG. 11.

In this case, the display control unit 400 receives frequency information (or corresponding time information ts or 0.1ts) of the abscissa in FIG. 11 from the sequential control unit 800.

A spectrum waveform shown on the lower side in FIG. 11 is obtained such that spectra in a frequency span (fst - fsp) on the abscissa are plotted on the ordinate in units of dBm.

In this case, the abscissa is connected by an envelope curve. However, in fact, the abscissa is, for example, data of 512 points, a frequency interval of the points is (fst - fsp)/L (Hz), and ts is set as a time interval.

A dotted-line frame D on the lower side in FIG. 11 is obtained such that a delta marker (marker having a variable width and a variable position) designated by operating means (not shown) on the panel is generated and displayed by the display control unit 400.

A spectrum display on the upper side in FIG. 11 is obtained such that the display control unit 400 reads data obtained at intervals of (fst - fsp)/10L (Hz) in a frequency range of f1 to f2 corresponding to the width of the delta marker designated by the panel from the storage unit 700 and magnified and displayed at 512 points on the same abscissa.

In a conventional spectrum analyzer, sweeping measurement is performed in a frequency span fst - fsp. Thereafter, sweeping measurement is performed in a frequency span f1 - f2. More specifically, sweeping measurement is performed two times, so that the same display as that of the spectrum display on the upper side in FIG. 11 can be performed.

However, in the second embodiment, the display can be achieved by performing sweeping measurement once in a frequency span fst - fsp by means of the interpolating unit 500.

The APD 300 performs sweeping measurement in the frequency span fst - fsp the number of times required for a hour rate, so that an amplitude probability including a frequency of the interval of (fst - fsp)/L (Hz) or the interval of (fst - fsp)/10L (Hz) as a parameter is calculated and output.

The display control unit 400 receives a calculation result of the APD 300 to cause the display unit 600 to perform a display shown in FIG. 12 or a display shown in FIG. 8B.

On the abscissa in FIG. 8B, in place of $f_{IN1}$, $f_{IN2}$, ..., for example, the interval of (fst - fsp)/L (Hz) including the frequency fst as a start is set.

More specifically, therefore, frequency components of an input RF signal and an interference wave and a distribution of an amplitude probability (time rate) can be measured and displayed as shown in FIG 12.

FIGS. 10 and 11 can also be applied to not only a spectrum analyzer but also a network analyzer or the like which transmits a signal to a network and receives a signal from the network to analyze the network.

The present invention can be applied to anything that converts, for example, rotation, vibration, or the like into an electric signal to measure the magnitude of the rotation, the vibration, or the like or converts the rotation, the vibration, or the like into a logarithm.

Therefore, according to the present invention described above, in order to solve the problems of the conventional technique, a technique which can obtained preferable log characteristics at a high speed by a digitally hardware configuration, for example, a logical circuit is employed, and a technique which calculates digital data set in a sampling interval by interpolation is employed. Consequently, a signal measuring/analyzing apparatus and a signal measuring/ analyzing method such as amplitude probability measurement or a spectrum analyzer which has a minimum memory capacity and can achieve high-speed processing can be provided.

**Claims**

1. A signal measuring apparatus comprising:

   a data converting unit (100) which converts an input signal into digital data having a predetermined number of bits with clocks having a predetermined cycle ts, and outputs phase detected data performing squared detection of two quadrature components of the digital data and adding the resultant squared quadrature components and a log converting unit (200) which performs logarithmic conversion of the phase-detected data output from the data converting unit (100),
   **characterized in that**
   the log converting unit (200) comprises:

   an exponent-mantissa separator (210) which receives the phase-detected data output from the data converting unit (100) and separates the phase-detected data into mantissa data expressing a mantissa part of the phase-detected data and exponent data expressing an exponent part of the phase-detected data to output the mantissa data and the exponent data;
   a mantissa calculating table (220) which is accessed by the mantissa data output from the exponent-mantissa separator (210) and which outputs a logarithm corresponding to the mantissa data stored in advance;
   an exponent output unit (230) which outputs a logarithm corresponding to the exponent data based on the exponent data output from the exponent-mantissa separator (210);
   an adder (240) which, in order to obtain an output logarithm corresponding to the amplitude of the input signal, adds the logarithm corresponding to the mantissa data output from the mantissa calculating table (220) to the logarithm corresponding to the exponent data output from the exponent output unit (230) and outputs an output logarithm corresponding to the phase-detected data, and
   an interpolating unit (500) inserted between the data converting unit (100) and the mantissa-exponent separator (210), the interpolating unit (500) receiving the clocks having the predetermined cycle ts, interpolating the phase-detected data output from the data converting unit (100) at an interval of ts/2N with N being an integer in the predetermined cycle ts, and transmitting an interpolated value to the exponent-mantissa separator (210).

2. The signal measuring apparatus according to claim 1, **characterized in that**
   the exponent output unit (230) comprises:

   an exponent calculating table (230) which is accessed by the exponent data output from the exponent-mantissa separator (210) and which outputs a logarithm corresponding to the exponent data stored in advance.

3. The signal measuring apparatus according to claim 1 or 2, **characterized in that**
   the exponent-mantissa separator (210) comprises:

   a decider (211) which receives the phase-detected data output from the data converting unit (100), discriminates a most significant bit of the phase-detected data in when receiving by using a logical circuit (211a, 211b), and outputs a discrimination result;
   a mantissa selector (212) which selects data of a plurality of bits including data of a predetermined number of lower bits from the discrimination result of the most significant bit output from the decider (211) and outputs the data as mantissa data expressing the mantissa part based on plurality of selected bit data; and
   an exponent determiner (213) which converts the most significant bit into identifiable identification data based on the discrimination result of the most significant bit output from the decider (211) and outputs the identification data as the exponent data expressing the exponent part.

**4.** The signal measuring apparatus according to any one of claims 1 to 3, **characterized in that** the interpolating unit (500) is configured to designate phase-detected data at a center (mts) of a range to be interpolated by the phase-detected data output at intervals of 1/N in the predetermined cycle ts, generate an extraction signal mts$\pm$p, p being -½+h/N, and h being an integer falling within the range from 0 to less than N, having a cycle ts/N in the range to be interpolated, weight the phase-detected data {p(mts)} at the center of the range to be interpolated and nearest phase-detected data {p((m-1)ts), p((m+1)ts)} corresponding to width ($\pm$p) of a space between the extraction signal and the center in the range to be interpolated, and generate the interpolated value every extraction signal based on weighted values.

**5.** The signal measuring apparatus according to any one of claims 1 to 4, **characterized in that** the data converting unit (100) comprises:

an analog/digital (A/D) converting unit (110) which converts the input signal into digital data having the predetermined number of bits with the clocks having the predetermined cycle ts;

a quadrature detecting unit (121) which performs a mixing operation to each component obtained by branching an output from the A/D converting unit (110) into two components independently of two local signals having phases different from each other by 90° and each having a predetermined frequency and outputs two quadrature components having phases orthogonalized at a frequency corresponding to a difference between the frequency of the input signal and the predetermined frequency;

a resolution bandwidth (RBW) filter unit (122) which performs predetermined bandwidth limitation to the two quadrature components output from the quadrature detecting unit (121) and outputs two bandwidth limitation resultant quadrature components;

a square detecting unit (123) which performs square detection to the two bandwidth limitation resultant quadrature components output from the RBW filter unit (122) and outputs two square detection resultant quadrature components; and

an adding unit (124) which adds the two square detection resultant quadrature components output from the square detecting unit (123).

**6.** The signal measuring apparatus according to any one of claims 1 to 5, **characterized by** further comprising:

an amplitude probability measuring unit (300),
the amplitude probability measuring unit (300) comprising:

a memory (310) which is accessed by using the output logarithm output from the adder (240) of the log converting unit (200) as an address value (k) and which outputs data corresponding to the output logarithm stored in advance to the address;

a data converter (320) which receives data {$G^{n-1}(k)$ : n is the number of times of access up to the previous access) at the address output from the memory (310), converts the data into data {$G^n(k)$} including information expressing the number of times of the latest access, and stores the data at identical address in the memory (310);

a frequency extracting unit (330) which receives the latest data $G^n(k)$ output from the memory, converts the data into the number of times {n(k)} of access performed to addresses by the output logarithm, and outputs the number of times; and

an amplitude probability calculating unit (340) which calculates an amplitude probability based on the number of times {n(k)} of access performed by the output logarithm output from the frequency extracting unit and outputs the amplitude probability.

**7.** A signal analyzing apparatus using the signal measuring apparatus according to any one of claims 1 to 3, further comprising:

a display control unit (400) which displays the logarithm depending on the phase-detected data output from the adder (240) of the log converting unit (200) on a display unit (600), **characterized in that** the data converting unit (100) comprises:

an RF unit (900) which sweeps a desired frequency bandwidth to an input high frequency (RF) signal, and thereby converts the input RF signal selectively received into a predetermined intermediate-frequency (IF) signal and outputs the IF signal;

an A/D converting unit (110) which analog/digital-converts the IF signal output from the RF unit (900) at clocks generated in the predetermined cycle ts and outputs the digital signal as digital data having a predetermined number of bits; and

an IF detecting unit (120) comprising:

a quadrature detecting unit (121) which performs a mixing operation to each component obtained by branching an output from the A/D converting unit (110) into two components independently of two local signals having phases different from each other by 90° and each having a predetermined frequency and outputs two quadrature components having phases orthogonalized at a frequency corresponding to a difference between the frequency of the input signal and the predetermined frequency;

a resolution bandwidth (RBW) filter unit (122) which performs predetermined bandwidth limitation to the two quadrature components output from the quadrature detecting unit (121) and outputs two bandwidth limitation resultant quadrature components;

a square detecting unit (123) which performs square detection to the two bandwidth limitation quadrature components output from the RBW filter unit (122) and outputs two square detection resultant quadrature components; and

an adding unit (124) which adds the two square detection resultant quadrature components output from the square detecting unit (123) and outputs phase-detected data.

8. The signal analyzing apparatus according to claim 7, **characterized by** further comprising:

an amplitude probability measuring unit (300),
the amplitude probability measuring unit (300) comprising:

a memory (310) which is accessed by using the output logarithm output from the adder (240) of the log converting unit (200) as an address value (k) and which outputs data corresponding to the output logarithm stored in advance to the address;

a data converter (320) which receives data $\{G^{n-1}(k)$ : n is the number of times of access up to the previous access) at the address output from the memory (310), converts the data into data $(G^n(k))$ including information expressing the number of times of the latest access, and stores the data at identical address in the memory;

a frequency extracting unit (330) which receives the latest data $G^n(k)$ output from the memory (310), converts the data into the number of times $\{n(k)\}$ of access performed to addresses by the output logarithm, and outputs the number of times; and

an amplitude probability calculating unit (340) which calculates an amplitude probability based on the number of times $\{n(k)\}$ of access performed by the output logarithm output from the frequency extracting unit (330), and outputs the amplitude probability, and **characterized in that**

the display control unit (400) is configured to cause the display unit (600) to selectively display the logarithm depending on the phase-detected data output from the adder (240) of the log converting unit (200) or the amplitude probability output from the amplitude probability calculating unit (340) of the amplitude probability measuring unit (300) on coordinates the abscissa of which indicates frequencies in the desired frequency band.

9. The signal analyzing apparatus according to claim 7 or 8, **characterized in that**
the display control unit (400) is configured to selectively display the logarithm corresponding to the phase-detected data output from the adder (240) of the log converting unit (200) or the amplitude probability output from the amplitude probability calculating unit (340) of the amplitude probability measuring unit (300) such that the frequencies in the desired frequency band on the abscissa are displayed by any of frequencies corresponding to an interval of the predetermined cycle is and frequencies corresponding to an interval of a cycle ts/N.

10. The signal analyzing apparatus according to claim 9, **characterized in that**
the display control unit (400) is configured to selectively display the logarithm depending on the phase-detected data output from the adder (240) of the log converting unit (200) or the amplitude probability output from the amplitude probability calculating unit (340) of the amplitude probability measuring unit (300) such that the frequencies in the desired frequency bandwidth on the abscissa are displayed by frequencies corresponding to an interval of the predetermined cycle is and some of the frequencies are magnified and displayed by the frequencies corresponding to the interval of the cycle ts/N.

11. The signal analyzing apparatus according to claim 9, **characterized in that**

the interpolating unit (500) is configured to designate phase-detected data at a center (mts) of a range to be interpolated by the phase-detected data output at intervals of 1/N in a predetermined cycle ts, generate an extraction signal mts±p, p being -½+h/N, and h being an integer falling within the range from 0 to less than N, having a cycle ts/N in the range to be interpolated, weight the phase-detected data {p(mts)} at the center of the range to be interpolated and nearest phase-detected data {p((m-1)ts), p((m+1)ts)} corresponding to width (±p) of a space between the extraction signal and the center in the range to be interpolated, and generate the interpolated value every extraction signal based on weighted values.

**12.** A signal measuring method comprising the steps of:

preparing a data converting unit (100) and a log converting unit (200);
causing the data converting unit (100) to convert an input signal into digital data having a predetermined number of bits at clocks having a predetermined cycle is and and outputs phase detected data by performing squared detection of two quadrature components of the digital data to and adding the resultant squared quadrature components ; and
causing the log converting unit (200) to perform logarithmic conversion of the phase-detected data;
**characterized by** further comprising the steps of :

preparing n exponent-mantissa separator (210), a mantissa calculating table (220), an exponent output unit (230), and an adder (240);
causing the exponent-mantissa separator (210) to receive the phase-detected data and to separate the phase-detected data into mantissa data expressing a mantissa part of the phase-detected data and exponent data expressing an exponent part of the phase-detected data to output the mantissa data and the exponent data;
outputting an output logarithm corresponding to the mantissa data stored in advance from the mantissa calculating table (220) to be accessed by the mantissa data;
causing the exponent output unit (230) to output a logarithm corresponding to the exponent data based on the exponent data;
causing the adder (240) to, in order to obtain an output logarithm corresponding to the amplitude of the input signal, add the logarithm corresponding to the mantissa data to the logarithm corresponding to the exponent data and output an output logarithm corresponding to the phase-detected data,
preparing an interpolating unit (500); and
causing the interpolating unit (500) to receive clocks generated in the predetermined cycle ts, interpolate the phase-detected data output from the data converting unit (100) at an interval of ts/2N with N being an integer in the predetermined cycle ts, and transmit an interpolated value to the exponent-mantissa separator (210).

**13.** The signal measuring method according to claim 12, **characterized in that**
the exponent output unit (230) comprises:

an exponent calculating table (230) which is accessed by the exponent data output from the exponent-mantissa separator (210) and which outputs a logarithm corresponding to the exponent data stored in advance.

**14.** The signal measuring method according to claim 12 or 13, **characterized in that**
the exponent-mantissa separator (210) comprises:

a decider (211) which receives the phase-detected data output from the data converting unit (100), discriminates a most significant bit of the received phase-detected data by a logical circuit (211a, 211b), and outputs the discrimination result;
a mantissa selector (212) which selects data of a plurality of bits including data of a predetermined number of lower bits from the discrimination result of the most significant bit output from the decider (211) and outputs the data as mantissa data expressing the mantissa part based on the plurality of selected bit data; and
an exponent determiner (213) which converts the most significant bit into identifiable identification data based on the discrimination result of the most significant bit output from the decider (211) and outputs the identification data as exponent data expressing the exponent part.

**15.** The signal measuring method according to claim 14, **characterized in that**
the interpolating unit (500) is configured to designate phase-detected data at the center (mts) of a range to be interpolated by the phase-detected data output at intervals of 1/N in the predetermined cycle ts, generate an extraction signal mts±p, p being -½+h/N, and h being an integer falling within the range from 0 to less than N, having a cycle ts/N in the range to be interpolated, weight the phase-detected data {p(mts)) at the center of the range to be interpolated and nearest phase-detected data {p((m-1)ts), p((m+1)ts)) depending on width (±p) of a space between the extraction signal and the center in the range to be interpolated, and generate the interpolated value every extraction signal based on weighted values.

16. The signal measuring method according to any one of claims 12 to 15, **characterized in that** the data converting unit (100) comprises:

an analog/digital (A/D) converting unit (110) which converts the input signal into digital data having the predetermined number of bits at clocks generated in the predetermined cycle ts;
a quadrature detecting unit (121) which performs a mixing operation to each component obtained by branching an output from the A/D converting unit (110) into two components independently of two local signals having phases different from each other by 90° and each having a predetermined frequency and outputs two quadrature components having phases orthogonalized at a frequency corresponding to a difference between the frequency of the input signal and the predetermined frequency;
a resolution bandwidth (RBW) filter unit (122) which performs predetermined bandwidth limitation to the two quadrature components output from the quadrature detecting unit (121) and outputs the resultant quadrature components;
a square detecting unit (123) which performs square detection to the two quadrature components output from the RBW filter unit (122) and outputs the resultant quadrature components; and
an adding unit (124) which adds the two quadrature components output from the square detecting unit (123).

17. The signal measuring method according to any one of claims 12 to 16, **characterized by** further comprising the steps of:

preparing an amplitude probability measuring unit (300) comprising a memory (310), a data converter (320), a frequency extracting unit (330), and an amplitude probability calculating unit (340);
outputting data corresponding to the output logarithm stored in advance to the address from the memory (310) which is accessed by using the output logarithm as an address value (k);
causing the data converter (320) to receive data {$G^{n-1}(k)$ : n is the number of times of access up to the previous access} at the address output from the memory (310), convert the data into data {$G^n(k)$} including information expressing the number of times of the latest access, and store the data at identical address in the memory (310);
causing the frequency extracting unit (330) to receive the latest data $G^n(k)$ output from the memory and convert the
data into the number of times {n(k)} of access performed to addresses by the output logarithm to output the number of times; and
causing the amplitude probability calculating unit (340) to calculate an amplitude probability based on the output of the number of times {n(k)} of access performed by the output logarithm and output the amplitude probability.

18. A signal analyzing method using the signal measuring method according to any one of claims 12 to 14, further comprising the steps of:

preparing a high-frequency (RF) unit (900), an analog/digital (A/D) converting unit (110), an IF detecting unit (120), and a log converting unit (200);
causing the RF unit (900) to sweep a desired frequency bandwidth to an input RF signal, and thereby to convert the input RF signal selectively received into a predetermined intermediate frequency (IF) signal and output the intermediate frequency signal; and
causing the A/D converting unit (110) to analog/digital-convert the IF signal at clocks generated in the predetermined cycle ts and output the digital signal as digital data having a predetermined number of bits;
preparing an IF detecting unit (120) comprising a quadrature detecting unit (121), a resolution bandwidth (RBW) filter unit (122), a square detecting unit (123), and an adding unit (124);
causing the quadrature detecting unit (121) to perform a mixing operation to each component obtained by branching an output from the A/D converting unit into two components independently of two local signals having phases different from each other by 90° and each having a predetermined frequency and output two quadrature components having phases orthogonalized at a frequency corresponding to a difference between the frequency of the input signal and the predetermined frequency;

causing the RBW filter unit (122) to perform predetermined bandwidth limitation to the two quadrature components and output the resultant quadrature components;

causing the square detecting unit (123) to perform square detection to the two quadrature components subjected to the bandwidth limitation and output two square detection quadrature components;

causing the adding unit (124) to add the two square detection quadrature components output from the square detecting unit (123) and output as phase-detected data;

preparing a display unit (600) and a display control unit (400); and

causing the display control unit (400) to display the logarithm depending on the phase-detected data output from the adder (240) of the log converting unit (200) on the display unit (600),

**characterized by** further comprising the steps of:

preparing a log converting unit (200) comprising an exponent-mantissa separator (210), a mantissa calculating table (220), an exponent output unit (230), and an adder (240);

causing the exponent-mantissa separator (210) to receive the phase-detected data and separate the phase-detected data into mantissa data expressing a mantissa part of the phase-detected data and exponent data expressing an exponent part of the data and output the mantissa data and the exponent data;

outputting a logarithm corresponding to the mantissa data stored in advance from the mantissa calculating table (220) which is accessed by the mantissa data;

causing the exponent output unit (230) to output a logarithm corresponding to the exponent data based on the exponent data;

causing the adder (240) to add the logarithm corresponding to the mantissa data output from the mantissa calculating table (220) to the logarithm corresponding to the exponent data output from the exponent output unit (230) and output a logarithm depending on the phase-detected data; and

causing the display control unit (400) to display the logarithm depending on the phase-detected data on the display unit (600).

**19.** The signal analyzing method according to claim 18, **characterized by** further comprising the steps of:

preparing an amplitude probability measuring unit (300) comprising a memory (310), a data converter (320), a frequency extracting unit (330), and an amplitude probability calculating unit (340);

outputting data corresponding to the output logarithm stored in advance to the address from the memory (310) which is accessed by using the output logarithm as an address value (k);

causing the data converter (320) to receive data $\{G^{n-1}(k)$ : n is the number of times of access up to the previous access$\}$ at the address output from the memory (310), convert the data into data $\{G^n(k)\}$ including information expressing the number of times of the latest access, and store the data at identical address in the memory (310);

causing the frequency extracting unit (330) to receive the latest data $G^n(k)$ output from the memory (310), convert the data into the number of times $\{n(k)\}$ of access performed to addresses by the output logarithm, and output the number of times;

causing the amplitude probability calculating unit (340) to calculate an amplitude probability based on the output of the number of times $\{n(k)\}$ of access performed by the output logarithm; and

causing the display control unit (400) to selectively display the logarithm depending on the phase-detected data output from the adder (240) of the log converting unit (200) or the amplitude probability output from the amplitude probability calculating unit (340) of the amplitude probability measuring unit (300) on coordinates the abscissa of which indicates frequencies in the desired frequency band.

**20.** The signal analyzing method according to claim 18 or 19, **characterized by** further comprising the step of:

causing the display control unit (400) to selectively display the logarithm depending on the phase-detected data or the amplitude probability on the display unit (600) such that the frequencies in the desired frequency band on the abscissa are displayed by any of frequencies corresponding to an interval of the predetermined cycle is and frequencies corresponding to an interval of a cycle ts/N.

**21.** The signal analyzing method according to claim 20, **characterized in that**

the display control unit (400) is configured to selectively display the logarithm depending on the phase-detected data output from the adder (240) of the log converting unit (200) or the amplitude probability output from the amplitude probability calculating unit (340) of the amplitude probability measuring unit (300) such that the frequencies in the desired frequency band on the abscissa are displayed by frequencies corresponding to an interval of the predetermined cycle is and some of the frequencies are magnified and displayed by the frequencies corresponding to the interval of the cycle ts/N.

22. The signal analyzing method according to claim 20, **characterized in that**
the interpolating unit (500) is configured to designate phase-detected data at the center (mts) of a range to be interpolated by the phase-detected data output at intervals of 1/N in the predetermined cycle ts, generate an extraction signal mts±p, p being -½+h/N, and h being an integer falling within the range from 0 to less than N, having a cycle ts/N in the range to be interpolated, weight the phase-detected data {p(mts)} at the center of the range to be interpolated and nearest phase-detected data {p((m-1)ts}, p((m+1)ts)} depending on width (±p) of a space between the extraction signal and the center in the range to be interpolated, and generate the interpolated value every extraction signal based on weighted values.


**Patentansprüche**

1. Signalmessvorrichtung, Folgendes umfassend:

eine Datenkonvertierungseinheit (100), die ein Eingangssignal in digitale Daten mit einer vorbestimmten Anzahl von Bits mit Takten mit einem vorbestlmmten Zyklus ts konvertiert und phasendetektierte Daten ausgibt, indem eine Quadratdetektion zweier Quadraturkomponenten der digitalen Daten durchgeführt wird und die sich ergebenden, Ins Quadrat erhobenen Quadraturkomponenten addiert werden, und
eine logarithmische Umrechnungseinheit (200), die eine logarithmische Umrechnung der aus der Datenkonvertierungseinheit (100) ausgegebenen phasendetektierten Daten durchführt,
**dadurch gekennzeichnet, dass**
die logarithmische Umrechnungseinheit (200) umfasst:

eine Exponenten/Mantissen-Trennvorrichtung (210), die die aus der Datenkonvertierungseinheit (100) ausgegebenen phasendetektierten Daten empfängt und die phasendetektierten Daten in Mantissendaten, die einen Mantissenteil der phasendetektierten Daten ausdrücken, und Exponentendaten trennt, die einen Exponententeil der phasendetektierten Daten ausdrücken, um die Mantissendaten und die Exponentendaten auszugeben;
eine Mantissenberechnungstabelle (220), auf die durch die aus der Exponenten/Mantissen-Trenneinrichtung (210) ausgegebenen Mantissendaten zugegriffen wird, und die einen Logarithmus ausgibt, der den vorab gespeicherten Mantissendaten entspricht;
eine Exponentenausgabeeinheit (230), die einen den Exponentendaten entsprechenden Logarithmus auf Grundlage der aus der Exponenten/Mantissen-Trenneinrichtung (210) ausgegebenen Exponentendaten ausgibt;
eine Addiereinrichtung (240), die, um einen Ausgabelogarithmus zu erhalten, der der Amplitude des Eingangssignals entspricht, den Logarithmus, der den aus der Mantissenberechnungstabelle (220) ausgegebenen Mantissendaten entspricht, zu dem Logarithmus addiert, der den aus der Exponentenausgabeeinheit (230) ausgegebenen Exponentendaten entspricht und einen Ausgabelogarithmus ausgibt, der den phasendetektierten Daten entspricht, und
eine Interpolationselnheit (500), die zwischen der Datenkonvertierungseinheit (100) und der Mantissen/Exponenten-Trenneinrichtung (210) eingesetzt ist, wobei die Interpolationselnheit (500) die Takte mit dem vorbestimmten Zyklus ts empfängt, die aus der Datenkonvertierungseinheit (100) ausgegebenen phasendetektierten Daten In einem Intervall ts/2N, wobei N eine ganze Zahl ist, in dem vorbestimmten Zyklus Interpoliert und einen interpollerten Wert an die Exponenten/Mantissen-Trenneinrichtung (210) überträgt.

2. Signalmessvorrichtung nach Anspruch 1, **dadurch gekennzeichnet, dass** die Expontenausgabeeinheit (230) umfasst:

eine Exponentenberechnungstabelle (230), auf die durch die aus der Exponenten/Mantissen-Trenneinrichtung (210) ausgegebenen Exponentendaten zugegriffen wird, und die einen Logarithmus ausgibt, der den vorab gespeicherten Exponentendaten entspricht.

3. Signalmessvorrichtung nach Anspruch 1 oder 2, **dadurch gekennzeichnet, dass** die Exponenten/Mantissen-Trenneinrichtung (210) umfasst:

eine Entscheidungseinrichtung (211) die die aus der Datenkonvertierungseinheit (100) ausgegebenen phasendetektierten Daten empfängt, beim Empfang unter Verwendung einer logischen Schaltung (211a, 211b) ein höchstwertiges Bit der phasendetektierten Daten unterscheidet und ein Unterscheidungsergebnis ausgibt, eine Mantissenauswahleinrichtung (212), die Daten aus einer Vielzahl von Bits, einschließlich Daten aus einer vorbestimmten Anzahl niederwertigerer Bits aus dem aus der Entscheidungseinrichtung (211) ausgegebenen Unterscheidungsergebnls der höchstwertigen Bits auswählt und die Daten als Mantissendaten ausgibt, die den Mantissenteil auf Grundlage einer Vielzahl von ausgewählten Bitdaten ausdrücken, und eine Exponentenbestimmungseinrichtung (213), die das höchstwertige Bit auf Grundlage des aus der Entscheidungseinrichtung (211) ausgegebenen Unterscheldungsergebnisses des höchstwertigen Bits in identifizierbare Identifizierungsdaten konvertiert und die Identifizierungsdaten als die den Exponententeil ausdrückenden Exponentendaten ausgibt.

4. Signalmessvorrichtung nach einem der Ansprüche 1 bis 3, **dadurch gekennzeichnet, dass** die Interpolationselnheit (500) dazu konfiguriert ist, phasendetektlerte Daten in einer Mitte (mts) eines zu Interpolierenden Bereichs durch die In Intervallen 1/N im vorbestimmten Zyklus ts ausgegebenen phasendetektierten Daten zu bezeichnen, ein Extraktionssignal $mts \pm p$, wobei $p$ $-\frac{1}{2}+h/N$ ist, und $h$ eine ganze Zahl ist, die In den Bereich von 0 bis unter N fällt, mit einem Zyklus ts/N in dem zu interpolierenden Bereich zu generleren, die phasendetektierten Daten {p(mts)} in der Mitte des zu interpolierenden Bereichs und die naheliegendsten phasendetektierten Daten {p((m-1)ts, p((m+1)ts)} entsprechend einer Weite ($\pm p$) eines Raums zwischen dem Extraktionssignal und der Mitte in dem zu interpolierenden Bereich zu gewichten und den Interpolationswert bei jedem Extraktionssignal auf Grundlage von Gewichtungswerten zu generieren.

5. Signalmessvorrichtung nach einem der Ansprüche 1 bis 4, **dadurch gekennzeichnet, dass** die Datenkonvertierungseinhelt (100) umfasst:

   eine Analog/Digital-(A/D)-Wandlerelnheit (110), die das Eingangssignal in digitale Daten mit der vorbestimmten Anzahl von Bits bei den Takten mit dem vorbestimmten Zyklus ts umwandelt;
   eine Quadraturerfassungseinheit (121), die eine Mischoperation an jeder Komponente durchführt, die erhalten wird, indem ein Ausgang aus der A/D-Wandlereinheit (110) unabhängig von zwei lokalen Signalen, mit Phasen, die sich voneinander um 90° unterscheiden und jeweils eine vorbestimmte Frequenz haben, in zwei Komponenten aufgezweigt wird, und zwei Quadraturkomponenten mit bei einer Frequenz orthogonalisierten Phasen ausgibt, die einer Differenz zwischen der Frequenz des Eingangssignals und der vorbestimmten Frequenz entspricht;
   eine Auflösungsbandbreiten-(RBW)-Filterelnheit (122), die eine vorbestimmte Bandbreitenbegrenzung an den zwei aus der Quadraturerfassungseinheit (121) ausgegebenen Quadraturkomponenten durchführt und zwei sich aus der Bandbreitenbegrenzung ergebende Quadraturkomponenten ausgibt;
   eine Quadraterfassungseinheit (123), die eine Quadraterfassung an den zwei aus der RBW-Filtereinheit (122) ausgegebenen, sich aus der Bandbreitenbegrenzung ergebenden Quadraturkomponenten durchführt und zwei sich aus der Quadraterfassung ergebende Quadraturkomponenten ausgibt; und
   eine Addiereinhelt (124), die die zwei aus der Quadraterfassungseinheit (123) ausgegebenen, sich aus der Quadraterfassung ergebenden Quadraturkomponenten addiert.

6. Signalmessvorrichtung nach einem der Ansprüche 1 bis 5, **dadurch gekennzeichnet, dass** sie darüber hinaus umfasst:

   eine Amplitudenwahrschelnlichkeitsmesseinheit (300),
   wobei die Amplitudenwahrscheinlichkeltsmesseinhelt (300) umfasst:

   einen Speicher (310), auf den zugegriffen wird, Indem der aus der Addiereinrichtung (240) der logarithmischen Umrechnungseinheit (200) ausgegebene Ausgabelogarithmus als Adressenwert (k) verwendet wird, und der Daten entsprechend dem vorab gespeicherten Ausgabelogarithmus an die Adresse ausgibt;
   einen Datenkonvertlerer (320), der Daten $\{G^{n-1}(k)$ : n ist die Anzahl der Zugriffshäufigkeit bis zum vorherigen Zugriff} an der aus dem Speicher (310) ausgegebenen Adresse empfängt, die Daten in Daten $\{G^n(k)\}$ konvertiert, die Information enthalten, die die Anzahl der Häufigkeit des letzten Zugriffs ausdrückt, und die Daten an derselben Adresse im Speicher (310) speichert;
   eine Frequenzextraktionseinheit (330), die die letzten aus dem Speicher ausgegebenen Daten $G^n(k)$ empfängt, die Daten durch den Ausgabelogarithmus in die Anzahl der an den Adressen erfolgten Zugriffshäufigkelt $\{n(k)\}$ konvertiert und die Häufigkeitsanzahl ausgibt; und
   eine Amplitudenwahrschelnlichkeitsberechnungseinheit (340), die eine Amplitudenwahrscheinlichkeit auf Grundlage der Anzahl der durch den aus der Frequenzextraktionseinheit ausgegebenen Ausgabelogarithmus erfolgten Zugriffshäufigkeit $\{n(k)\}$ berechnet und die Amplitudenwahrscheinlichkelt ausgibt.

7. Signalanalysevorrichtung, die sich der Signalmessvorrichtung nach einem der Ansprüche 1 bis 3 bedient und darüber hinaus umfasst:

eine Anzeigesteuereinheit (400), die den Logarithmus, der von den aus der Addiereinrichtung (240) der logarithmischen Umrechnungseinheit (200) ausgegebenen phasendetektierten Daten abhängt, auf einer Anzeigeeinheit (600) anzeigt, **dadurch gekennzeichnet, dass**
die Datenkonvertierungseinheit (100) umfasst:

eine RF-Elnheit (900), die eine gewünschte Frequenzbandbreite zu einem Eingangshochfrequenz-(RF)-Signal wobbelt und dadurch das selektiv empfangene Eingangs-RF-Signal in ein vorbestimmtes Zwischenfrequenz-(IF)-Signal umwandelt und das IF-Signal ausgibt;
eine A/D-Wandlereinheit (110), die das aus der RF-Einheit (900) ausgegebene IF-Signal bei Takten, die in dem vorbestimmten Zyklus ts erzeugt werden, analog/digital umwandelt und das digitale Signal als digitale Daten mit einer vorbestimmten Bitanzahl ausgibt; und
eine IF-Erfassungseinhelt (120), die umfasst:

eine Quadraturerfassungseinheit (121), die eine Mischoperation an jeder Komponente durchführt, die erhalten wird, indem ein Ausgang aus der A/D-Wandlereinhelt (110) unabhängig von zwei lokalen Signalen, mit Phasen, die sich voneinander um 90° unterscheiden und jeweils eine vorbestimmte Frequenz haben, in zwei Komponenten aufgezweigt wird, und zwei Quadraturkomponenten mit bei einer Frequenz orthogonalisierten Phasen ausgibt, die einer Differenz zwischen der Frequenz des Eingangssignals und der vorbestimmten Frequenz entspricht;
eine Auflösungsbandbreiten-(RBW)-Fiitereinhelt (122), die eine vorbestimmte Bandbreitenbegrenzung an den zwei aus der Quadraturerfassungseinheit (121) ausgegebenen Quadraturkomponenten durchführt und zwel sich aus der Bandbreitenbegrenzung ergebende Quadraturkomponenten ausgibt;
eine Quadraterfassungseinheit (123), die eine Quadraterfassung an den zwei aus der RBW-Filtereinheit (122) ausgegebenen, sich aus der Bandbreitenbegrenzung ergebenden Quadraturkomponenten durchführt und zwei sich aus der Quadraterfassung ergebende Quadraturkomponenten ausgibt; und
eine Addiereinheit (124), die die zwei aus der Quadraterfassungseinheit (123) ausgegebenen, sich aus der Quadraturerfassung ergebenden Quadraturkomponenten addiert und phasendetektierte Daten ausgibt..

8. Signalanalysevorrichtung nach Anspruch 7, **dadurch gekennzeichnet, dass** sie darüber hinaus umfasst:

eine Amplitudenwahrscheinlichkeitsmesselnheit (300),
wobei die Amplitudenwahrscheinlichkeitsmesselnheit (300) umfasst:

einen Speicher (310), auf den zugegriffen wird, Indem der aus der Addiereinrichtung (240) der logarithmischen Umrechnungseinheit (200) ausgegebene Ausgabelogarithmus als Adressenwert (k) verwendet wird, und der Daten entsprechend dem vorab gespeicherten Ausgabelogarithmus an die Adresse ausgibt;
einen Datenkonvertierer (320), der Daten $\{G^{n-1}(k)$ : n ist die Anzahl der Zugriffshäufigkeit bis zum vorherigen Zugriff$\}$ an der aus dem Speicher (310) ausgegebenen Adresse empfängt, die Daten in Daten $\{G^n(k)\}$ konvertiert, die Information enthalten, die die Anzahl der Häufigkeit des letzten Zugriffs ausdrückt, und die Daten an derselben Adresse im Speicher speichert;
eine Frequenzextraktionseinheit (330), die die letzten aus dem Speicher ausgegebenen Daten $G^n(k)$ empfängt, die Daten durch den Ausgabelogarithmus in die Anzahl der an den Adressen erfolgten Zugriffshäufigkelt $\{n(k)\}$ konvertiert und die Häufigkeitsanzahl ausgibt; und
eine Amplitudenwahrscheinlichkeitsberechnungseinheit (340), die eine Amplitudenwahrschelnlichkeit auf Grundlage der Anzahl der durch den aus der Frequenzextraktionseinhelt (330) ausgegebenen Ausgabelogarithmus erfolgten Zugriffshäufigkeit $\{n(k)\}$ berechnet und die Amplitudenwahrscheinlichkeit ausgibt, und **dadurch gekennzeichnet, dass**
die Anzeigesteuereinheit (400) dazu konfiguriert ist, zu bewirken, dass die Anzeigeeinheit (600) selektiv den Logarithmus, der von den aus der Addiereinrichtung (240) der logarithmischen Umrechnungseinheit (200) ausgegebenen phasendetektierten Daten oder der Amplitudenwahrscheinlichkeit abhängt, die aus der Amplitudenwahrscheinlichkeitsberechnungseinheit (340) der Amplitudenwahrscheinlichkeitsmesseinrichtung (300) ausgegeben wird, auf Koordinaten anzeigt, deren Abszisse Frequenzen in dem gewünschten Frequenzband angibt.

9. Signalanalysevorrichtung nach Anspruch 7 oder 8, **dadurch gekennzeichnet, dass**
die Anzeigesteuereinheit (400) dazu konfiguriert ist, den Logarithmus, der von den aus der Addiereinrichtung (240) der logarithmischen Umrechnungseinheit (200) ausgegebenen phasendetektierten Daten oder der Amplitudenwahrscheinlichkeit abhängt, die aus der Amplitudenwahrscheinlichkeitsberechnungseinheit (340) der Amplitudenwahrscheinlichkeitsmesseinrichtung (300) ausgegeben wird, selektiv so anzuzeigen, dass die Frequenzen in dem gewünschten Frequenzband auf der Abszisse durch irgendwelche von Frequenzen, die einem Intervall des vorbestimmten Zyklus is entsprechen, und Frequenzen, die einem Intervall eines Zyklus ts/N entsprechen, angezeigt werden.

10. Signalanalysevorrichtung nach Anspruch 9, **dadurch gekennzeichnet, dass**
die Anzeigesteuereinheit (400) dazu konfiguriert ist, den Logarithmus, der von den aus der Addiereinrichtung (240) der logarithmischen Umrechnungseinheit (200) ausgegebenen phasendetektierten Daten oder der Amplitudenwahrscheinlichkeit abhängt, die aus der Amplitudenwahrscheinlichkeitsberechnungseinheit (340) der Amplitudenwahrscheinllchkeitsmesseinrichtung (300) ausgegeben wird, selektiv so anzuzeigen, dass die Frequenzen in der gewünschten Frequenzbandbreite auf der Abszisse durch Frequenzen, die einem Intervall des vorbestimmten Zyklus is entsprechen, angezeigt werden, und einige der Frequenzen vergrößert und durch die Frequenzen angezeigt werden, die dem Intervall des Zyklus ts/N entsprechen.

11. Signalanalysevorrichtung nach Anspruch 9, **dadurch gekennzeichnet, dass**
die Interpolationseinheit (500) dazu konfiguriert ist, phasendetektierte Daten in einer Mitte (mts) eines zu interpolierenden Bereichs durch die In Intervallen 1/N in einem vorbestimmten Zyklus ts ausgegebenen phasendetektierten Daten zu bezeichnen, ein Extraktionssignal mts$\pm$p, wobei p -½+h/N ist, und h eine ganze Zahl ist, die in den Bereich von 0 bis unter N fällt, mit einem Zyklus ts/N In dem zu interpollerenden Bereich zu generieren, die phasendetektierten Daten {p(mts)} in der Mitte des zu interpolierenden Bereichs und die naheliegendsten phasendetektierten Daten {p((m-1)ts), p((m+1)ts)} entsprechend einer Weite ($\pm$p) eines Raums zwischen dem Extraktionssignal und der Mitte in dem zu interpolierenden Bereich zu gewichten und den Interpolationswert bei jedem Extraktionssignal auf Grundlage von Gewichtungswerten zu generieren.

12. Signalmessverfahren, das die folgenden Schritte umfasst:

Vorbereiten einer Datenkonversionseinheit (100) und einer logarithmischen Umrechnungseinheit (200);
Bewirken, dass die Datenkonversionseinheit (100) ein Eingangssignal in digitale Daten mit einer vorbestimmten Anzahl von Bits mit Takten mit einem vorbestimmten Zyklus is umwandelt und phasendetektierte Daten ausgibt, indem eine Quadratdetektion zweier Quadraturkomponenten der digitalen Daten durchgeführt wird und die sich ergebenden, Ins Quadrat erhobenen Quadraturkomponenten addiert werden; und
Bewirken, dass die logarithmische Umrechnungseinheit (200) eine logarithmische Umrechnung der phasendetektierten Daten durchführt;
**dadurch gekennzeichnet, dass** es darüber hinaus die folgenden Schritte umfasst:

Vorbereiten einer Exponenten/Mantissen-Trennvorrichtung (210), einer Mantissenberechnungstabelle (220), einer Exponentenausgabeeinheit (230) und einer Addiereinrichtung (240);
Bewirken, dass die Exponenten/Mantissen-Trennvorrichtung (210) die phasendetektlerten Daten empfängt und die phasendetektierten Daten In Mantissendaten, die einen Mantissenteil der phasendetektierten Daten ausdrücken, und Exponentendaten trennt, die einen Exponententeil der phasendetektierten Daten ausdrücken, um die Mantissendaten und die Exponentendaten auszugeben;
Ausgeben eines Ausgabelogarithmus entsprechend den vorab gespeicherten Mantissendaten aus der Mantissenberechnungstabelle (220), auf die durch die Mantissendaten zugegriffen werden soll;
Bewirken, dass die Exponentenausgabeeinheit (230) einen den Exponentendaten entsprechenden Logarithmus auf Grundlage der Exponentendaten ausgibt;
Bewirken, dass die Addiereinrichtung (240), um einen Ausgabelogarithmus zu erhalten, der der Amplitude des Eingangssignals entspricht, den Logarithmus, der den Mantissendaten entspricht, zu dem Logarithmus addiert, der den Exponentendaten entspricht und einen Ausgabelogarithmus ausgibt, der den phasendetektierten Daten entspricht,
Vorbereiten einer Interpolationseinheit (500); und
Bewirken, dass die Interpolationseinheit (500) Takte empfängt, die in dem vorbestimmten Zyklus ts erzeugt werden, die aus der Datenkonvertlerungseinheit (100) ausgegebenen phasendetektierten Daten in einem Intervall von ts/2N, wobei N eine ganze Zahl ist, in dem vorbestimmten Zyklus ts interpoliert und einen interpollerten Wert an die Exponenten/Mantissen-Trenneinrichtung (210) überträgt.

13. Signalmessverfahren nach Anspruch 12, **dadurch gekennzeichnet, dass**
die Exponentenausgabeeinheit (230) umfasst:

eine Exponentenberechnungstabelle (230), auf die durch die aus der Exponenten/Mantissen-Trenneinrichtung (210) ausgegebenen Exponentendaten zugegriffen wird, und die einen Logarithmus ausgibt, der den vorab gespeicherten Exponentendaten entspricht.

14. SIgnalmessverfahren nach Anspruch 12 oder 13, **dadurch gekennzeichnet, dass**
die Exponenten/Mantissen-Trenneinrichtung (210) umfasst:

eine Entscheidungseinrichtung (211) die die aus der Datenkonvertierungselnheit (100) ausgegebenen phasendetektierten Daten empfängt, durch eine logische Schaltung (211a, 211b) ein höchstwertiges Bit der empfangenen phasendetektierten Daten unterscheidet und das Unterscheidungsergebnis ausgibt;
eine Mantissenauswahleinrlchtung (212), die Daten aus einer Vielzahl von Bits, einschließlich Daten aus einer vorbestimmten Anzahl nlederwertigerer Bits aus dem aus der Entscheidungseinrichtung (211) ausgegebenen Unterscheidungsergebnis der höchstwertigen Bits auswählt und die Daten als Mantissendaten ausgibt, die den Mantissenteil auf Grundlage einer Vielzahl von ausgewählten Bitdaten ausdrücken; und
eine Exponentenbestimmungseinrichtung (213), die das höchstwertige Bit auf Grundlage des aus der Entscheidungseinrichtung (211) ausgegebenen Unterscheidungsergebnisses des höchstwertigen Bits in identiflzlerbare Identifizierungsdaten konvertiert und die Identifizierungsdaten als die den Exponententeil ausdrückenden Exponentendaten ausgibt.

15. Signalmessverfahren nach Anspruch 14, **dadurch gekennzeichnet, dass**
die Interpolationseinheit (500) dazu konfiguriert ist, phasendetektierte Daten in der Mitte (mts) eines zu interpolierenden Bereichs durch die in Intervallen 1/N im vorbestimmten Zyklus ts ausgegebenen phasendetektierten Daten zu bezeichnen, ein Extraktlonsslgnal mts$\pm$p, wobei p -½+h/N ist, und h eine ganze Zahl Ist, die in den Bereich von 0 bis unter N fällt, mit einem Zyklus ts/N In dem zu Interpolierenden Bereich zu generieren, die phasendetektierten Daten {p(mts)} in der Mitte des zu interpolierenden Bereichs und die naheliegendsten phasendetektierten Daten {p((m-1)ts, p((m+1)ts)} entsprechend einer Weite ($\pm$p) eines Raums zwischen dem Extraktionsslgnal und der Mitte In dem zu interpolierenden Bereich zu gewichten und den Interpolatlonswert bei jedem Extraktionssignal auf Grundlage von Gewlchtungswerten zu generieren.

16. Signalmessverfahren nach einem der Ansprüche 12 bis 15, **dadurch gekennzeichnet, dass**
die die Datenkonvertierungseinheit (100) umfasst:

eine Analog/Digital-(A/D)-Wandlereinheit (110), die das Eingangssignal in digitale Daten mit der vorbestimmten Anzahl von Bits bei in dem vorbestimmten Zyklus ts erzeugten Takten umwandelt;
eine Quadraturerfassungseinheit (121), die eine Mischoperation an jeder Komponente durchführt, die erhalten wird, indem ein Ausgang aus der A/D-Wandlereinhelt (110) unabhängig von zwei lokalen Signalen, mit Phasen, die sich voneinander um 90° unterscheiden und jeweils eine vorbestimmte Frequenz haben, in zwei Komponenten aufgezweigt wird, und zwei Quadraturkomponenten mit bei einer Frequenz orthogonalisierten Phasen ausgibt, die einer Differenz zwischen der Frequenz des Eingangssignals und der vorbestimmten Frequenz entspricht;
eine Auflösungsbandbreiten-(RBW)-Filtereinhelt (122), die eine vorbestimmte Bandbreitenbegrenzung an den zwei aus der Quadraturerfassungseinheit (121) ausgegebenen Quadraturkomponenten durchführt und die sich ergebenden Quadraturkomponenten ausgibt;
eine Quadraterfassungseinheit (123), die eine Quadraterfassung an den zwei aus der RBW-Filtereinheit (122) ausgegebenen Quadraturkomponenten durchführt und die sich ergebenden Quadraturkomponenten ausgibt; und
eine Addierelnhelt (124), die die zwei aus der Quadraterfassungselnheit (123) ausgegebenen Quadraturkomponenten addiert.

17. Signalmessverfahren nach einem der Ansprüche 12 bis 16, **dadurch gekennzeichnet, dass** es darüber hinaus die folgenden Schritte umfasst:

Vorbereiten einer Amplitudenwahrscheinlichkeltsmesseinheit (300), die einen Speicher (310), einen Datenkonvertlerer (320), eine Frequenzextraktionseinheit (330) und eine Amplitudenwahrschelnlichkeitsberechnungseinheit (340) umfasst;

Ausgeben von dem vorab gespeicherten Ausgabelogarithmus entsprechenden Daten an die Adresse aus dem Speicher (310), auf den durch Verwendung des Ausgabelogarithmus als Adressenwert (k) zugegriffen wird;

Bewirken, dass der Datenkonvertierer (320) Daten $\{G^{n-1}(k) : n$ ist die Anzahl der Zugrlffshäufigkeit bis zum vorherigen Zugriff$\}$ an der aus dem Speicher (310) ausgegebenen Adresse empfängt, die Daten in Daten $\{G^{n}(k)\}$ konvertiert, die Information enthalten, die die Anzahl der Häufigkeit des letzten Zugriffs ausdrückt, und die Daten an derselben Adresse Im Speicher (310) speichert;

Bewirken, dass die Frequenzextraktionseinhelt (330) die letzten aus dem Speicher ausgegebenen Daten $G^{n}(k)$ empfängt und die Daten durch den Ausgabelogarithmus In die Anzahl der an den Adressen erfolgten Zugriffshäufigkeit $\{n(k)\}$ konvertiert und die Häufigkeitsanzahl ausgibt; und

Bewirken, dass die Amplitudenwahrscheinlichkeitsberechnungseinheit (340) eine Amplitudenwahrscheinlichkeit auf Grundlage der Anzahl der durch den Ausgabelogarithmus erfolgten Zugriffshäufigkeit $\{n(k)\}$ berechnet und die Amplitudenwahrscheinlichkeit ausgibt.

18. Signalanalysierverfahren, das sich des Signalmessverfahrens nach einem der Ansprüche 12 bis 14 bedient, darüber hinaus die folgenden Schritte umfassend:

Vorbereiten einer Hochfrequenz-(RF)-Einheit (900), einer Analog/DIgltal-(A/D)-Wandlereinhelt (110), einer IF-Erfassungseinheit (120) und einer logarithmlschen Umrechnungseinhelt (200);

Bewirken, dass die RF-Einheit (900) eine gewünschte Frequenzbandbreite zu einem Eingangs-RF-SIgnal wobbelt und dadurch das selektiv empfangene Eingangs-RF-Signal in ein vorbestimmtes Zwischenfrequenz-(IF)-Signal umwandelt und das IF-Signal ausgibt; und

Bewirken, dass die A/D-Wandlereinheit (110) das IF-SIgnal bei Takten, die in dem vorbestimmten Zyklus ts erzeugt werden, analog/digital umwandelt und das digitale Signal als digitale Daten mit einer vorbestimmten Bitanzahl ausgibt;

Vorbereiten einer IF-Erfassungseinheit (120), die eine Quadraturerfassungseinheit (121), eine Auflösungsbandbreiten-(RBW)-Filtereinheit (122), eine Quadraterfassungseinheit (123) und eine Addiereinheit (124) umfasst;

Bewirken, dass die Quadraturerfassungseinheit (121) eine Mischoperation an jeder Komponente durchführt, die erhalten wird, indem ein Ausgang aus der A/D-Wandlereinheit unabhängig von zwei lokalen Signalen, mit Phasen, die sich voneinander um 90° unterscheiden und jeweils eine vorbestimmte Frequenz haben, in zwei Komponenten aufgezweigt wird, und zwei Quadraturkomponenten mit bei einer Frequenz orthogonalisierten Phasen ausgibt, die einer Differenz zwischen der Frequenz des Eingangssignals und der vorbestimmten Frequenz entspricht;

Bewirken, dass die Auflösungsbandbreiten-(RBW)-Filtereinheit (122) eine vorbestimmte Bandbreitenbegrenzung an den zwei Quadraturkomponenten durchführt und die sich ergebenden Quadraturkomponenten ausgibt;

Bewirken, dass die Quadraterfassungseinheit (123) eine Quadraterfassung an den zwei der Bandbreitenbegrenzung unterzogenen Quadraturkomponenten durchführt und zwei Quadraterfassungsquadraturkomponenten ausgibt;

Bewirken, dass die Addierelnheit (124) die zwei aus der Quadraterfassungseinheit (123) ausgegebenen Quadraterfassungsquadraturkomponenten addiert und als phasendetektierte Daten ausgibt;

Vorbereiten einer Anzeigeeinheit (600) und einer Anzeigesteuereinheit (400); und

Bewirken, dass die Anzeigesteuereinheit (400) den Logarithmus, der von den aus der Addiereinrichtung (240) der logarithmischen Umrechnungseinheit (200) ausgegebenen phasendetektierten Daten abhängt, auf der Anzeigeeinheit (600) anzeigt,

dadurch gekennzeichnet, dass es darüber hinaus die folgenden Schritte umfasst:

Vorbereiten einer logischen Umrechnungseinhelt (200), die eine Exponenten/Mantlssen-Trennvorrlchtung (210), eine Mantissenberechnungstabelle (220) eine Exponentenausgabeeinheit (230) und eine Addiereinrichtung (240) umfasst;

Bewirken, dass die Exponenten/Mantissen-Trennvorrichtung (210) die phasendetektierten Daten empfängt und die phasendetektlerten Daten in Mantissendaten, die einen Mantissentell der phasendetektierten Daten ausdrücken, und Exponentendaten trennt, die einen Exponententeil der phasendetektierten Daten ausdrücken, und die Mantissendaten und die Exponentendaten ausgibt;

Ausgeben eines den vorab gespeicherten Mantissendaten entsprechenden Logarithmus aus der Mantissenberechnungstabelle (220), auf die durch die Mantissendaten zugegriffen wird;

Bewirken, dass die Exponentenausgabeelnheit (230) einen den Exponentendaten entsprechenden Logarithmus auf Grundlage der Exponentendaten ausgibt;

Bewirken, dass die Addiereinrichtung (240) den Logarithmus, der den aus der Mantissenberechnungstabelle (220) ausgegebenen Mantissendaten entspricht, zu dem Logarithmus addiert, der den aus der Exponentenausgabeeinheit (230) ausgegebenen Exponentendaten entspricht und einen Logarithmus ausgibt, der von den phasendetektierten Daten abhängt; und

Bewirken, dass die Anzeigesteuereinheit (400) den Logarithmus, der von den phasendetektierten Daten abhängt, auf der Anzeigeeinheit (600) anzeigt.

**19.** Signalanalyslerverfahren nach Anspruch 18, **dadurch gekennzeichnet, dass** es darüber hinaus die folgenden Schritte umfasst:

Vorbereiten einer Amplitudenwahrschelnlichkeitsmesseinheit (300), die einen Speicher (310), einen Datenkonvertierer (320), eine Frequenzextraktionseinhelt (330) und eine Amplitudenwahrschelnllchkeitsberechnungseinheit (340) umfasst;

Ausgeben von dem vorab gespeicherten Ausgabelogarithmus entsprechenden Daten an die Adresse aus dem Speicher (310), auf den durch Verwendung des Ausgabelogarithmus als Adressenwert (k) zugegriffen wird;

Bewirken, dass der Datenkonvertlerer (320) Daten $\{G^{n-1}(k) : n$ Ist die Anzahl der Zugriffshäufigkeit bis zum vorherigen Zugriff$\}$ an der aus dem Speicher (310) ausgegebenen Adresse empfängt, die Daten In Daten $\{G^{n}(k)\}$ konvertiert, die Information enthalten, die die Anzahl der Häufigkeit des letzten Zugriffs ausdrückt, und die Daten an derselben Adresse im Speicher (310) speichert;

Bewirken, dass die Frequenzextraktionseinheit (330) die letzten aus dem Speicher (310)ausgegebenen Daten $G^{n}(k)$ empfängt, die Daten durch den Ausgabelogarithmus In die Anzahl der an den Adressen erfolgten Zugriffshäufigkeit $\{n(k)\}$ konvertiert und die Häuflgkeltsanzahl ausgibt;

Bewirken, dass die Amplitudenwahrscheinlichkeltsberechnungseinheit (340) eine Amplitudenwahrscheinlichkeit auf Grundlage der Anzahl der durch den Ausgabelogarithmus erfolgten Zugriffshäuflgkeit $\{n(k)\}$ berechnet; und

Bewirken, dass die Anzeigesteuereinheit (400) selektiv den Logarithmus, der von den aus der Addiereinrichtung (240) der logarithmischen Umrechnungseinheit (200) ausgegebenen phasendetektierten Daten oder der Amplitudenwahrschelnlichkelt abhängt, die aus der Amplitudenwahrscheinlichkeitsberechnungseinheit (340) der Amplitudenwahrscheinlichkeltsmesseinrichtung (300) ausgegeben wird, auf Koordinaten anzeigt, deren Abszisse Frequenzen in dem gewünschten Frequenzband angibt.

**20.** Signalanalysierverfahren nach Anspruch 18 oder 19, **dadurch gekennzeichnet, dass** es darüber hinaus die folgenden Schritte umfasst:

Bewirken, dass die Anzeigesteuereinheit (400) den Logarithmus, der von den phasendetektierten Daten oder der Amplitudenwahrscheinlichkeit abhängt, auf der Anzeigeeinheit (600) selektiv so anzeigt, dass die Frequenzen in dem gewünschten Frequenzband auf der Abszisse durch irgendwelche von Frequenzen, die einem Intervall des vorbestimmten Zyklus is entsprechen, und Frequenzen, die einem Intervall eines Zyklus ts/N entsprechen, angezeigt werden.

**21.** Signalanalysierverfahren nach Anspruch 20, **dadurch gekennzeichnet, dass**
die Anzeigesteuereinheit (400) dazu konfiguriert ist, den Logarithmus, der von den aus der Addiereinrichtung (240) der logarithmischen Umrechnungseinheit (200) ausgegebenen phasendetektierten Daten oder der Amplitudenwah-schelnlichkeit abhängt, die aus der Amplitudenwahrscheinlichkeitsberechnungseinheit (340) der Amplitudenwah-scheinlichkeitsmesseinrichtung (300) ausgegeben wird, selektiv so anzuzeigen, dass die Frequenzen in dem gewünschten Frequenzband auf der Abszisse durch irgendwelche von Frequenzen, die einem Intervall des vorbestimmten Zyklus is entsprechen, und einige der Frequenzen vergrößert und durch die Frequenzen angezeigt werden, die dem Intervall des Zyklus ts/N entsprechen.

**22.** Signalanalysierverfahren nach Anspruch 20, **dadurch gekennzeichnet, dass**
die Interpolationseinheit (500) dazu konfiguriert ist, phasendetektierte Daten in der Mitte (mts) eines zu interpolierenden Bereichs durch die in Intervallen 1/N im vorbestimmten Zyklus ts ausgegebenen phasendetektierten Daten zu bezeichnen, ein Extraktionssignal mts$\pm$p, wobei p -½+h/N ist, und h eine ganze Zahl Ist, die in den Bereich von 0 bis unter N fällt, mit einem Zyklus ts/N in dem zu interpolierenden Bereich zu generieren, die phasendetektierten Daten $\{p(mts)\}$ in der Mitte des zu Interpolierenden Bereichs und die naheliegendsten phasendetektierten Daten $\{p((m-1)ts, p((m+1)ts)\}$ entsprechend einer Weite ($\pm$p) eines Raums zwischen dem Extraktionss|gnal und der Mitte in dem zu interpolierenden Bereich zu gewichten und den Interpolationswert bei jedem Extraktionssignal auf Grundlage von Gewichtungswerten zu generieren.

**Revendications**

1. Appareil de mesure de signal comprenant :

   une unité de conversion de données (100) qui convertit un signal d'entrée en des données numériques ayant un nombre prédéterminé de bits avec des horloges ayant un cycle prédéterminé ts, et délivre en sortie des données de phase détectée en effectuant une détection de carré de deux composantes en quadrature des données numériques, et ajoutant les composantes en quadrature, élevées au carré, résultantes, et
   une unité de conversion logarithmique (200) qui effectue une conversion logarithmique des données de phase détectée délivrées en sortie de l'unité de conversion de données (100),
   **caractérisé en ce que**
   l'unité de conversion logarithmique (200) comprend :

   un séparateur exposant-mantisse (210) qui reçoit les données de phase détectée délivrées en sortie de l'unité de conversion de données (100) et sépare les données de phase détectée en des données de mantisse exprimant une partie de mantisse des données de phase détectée et des données d'exposant exprimant une partie d'exposant des données de phase détectée pour délivrer en sortie les données de mantisse et les données d'exposant ;
   une table de calcul de mantisse (220) accessible par les données de mantisse délivrées en sortie du séparateur exposant-mantisse (210) et qui délivre en sortie un logarithme correspondant aux données de mantisse préalablement stockées ;
   une unité de sortie d'exposant (230) qui délivre en sortie un logarithme correspondant aux données d'exposant sur la base des données d'exposant délivrées en sortie du séparateur exposant-mantisse (210) ;
   un additionneur (240) qui, afin d'obtenir un logarithme de sortie correspondant à l'amplitude du signal d'entrée, ajoute le logarithme correspondant aux données de
   mantisse délivrées en sortie de la table de calcul de mantisse (220) au logarithme correspondant aux données d'exposant délivrées en sortie de l'unité de sortie d'exposant (230) et délivre en sortie un logarithme de sortie correspondant aux données de phase détectée, et
   une unité d'interpolation (500) insérée entre l'unité de conversion de données (100) et le séparateur mantisse-exposant (210), l'unité d'interpolation (500) recevant les horloges ayant le cycle prédéterminé ts, interpolant les données de phase détectée délivrées en sortie de l'unité de conversion de données (100) à un intervalle de ts/2N avec N étant un entier dans le cycle prédéterminé ts, et transmettant une valeur interpolée au séparateur mantisse-exposant (210).

2. Appareil de mesure de signal selon la revendication 1, **caractérisé en ce que**
   l'unité de sortie d'exposant (230) comprend :

   une table de calcul d'exposant (230) qui est accessible par les données d'exposant délivrées en sortie du séparateur exposant-mantisse (210) et qui délivre en sortie un logarithme correspondant aux données d'exposant préalablement stockées.

3. Appareil de mesure de signal selon la revendication 1 ou 2, **caractérisé en ce que**
   le séparateur exposant-mantisse (210) comprend :

   un décideur (211) qui reçoit les données de phase détectée délivrées en sortie de l'unité de conversion de données (100), discrimine le bit le plus significatif parmi les données de phase détectée lorsqu'elles sont reçues en utilisant un circuit logique (211a, 211b), et délivre en sortie un résultat de discrimination ;
   un sélecteur de mantisse (212) qui sélectionne des données d'une pluralité de bits comportant des données d'un nombre prédéterminé de bits inférieurs à partir du résultat de discrimination du bit le plus significatif délivré en sortie du décideur (211) et délivre en sortie les données en tant que données de mantisse exprimant la partie de mantisse sur la base d'une pluralité de données de bits sélectionnées ; et
   un dispositif de détermination d'exposant (213) qui convertit le bit le plus significatif en des données d'identification identifiables sur la base du résultat de discrimination du bit le plus significatif délivré en sortie du décideur (211) et délivre en sortie les données d'identification en tant que données d'exposant exprimant la partie d'exposant.

**4.** Appareil de mesure de signal selon l'une quelconque des revendications 1 à 3, **caractérisé en ce que** l'unité d'interpolation (500) est configurée pour désigner des données de phase détectée à un centre (mts) d'une plage à interpoler par les données de phase détectée délivrées en sortie à des intervalles de 1/N dans le cycle prédéterminé ts, pour générer un signal d'extraction mts±p, p étant -1/2+h/N, et h étant un entier se trouvant dans la plage allant de 0 à moins de N, ayant un cycle ts/N dans la plage à interpoler, pour pondérer les données de phase détectée {p(mts)} au centre de la plage à interpoler et des données de phase détectée les plus proches {p((m-1)ts), p((m+1) ts)} correspondant à la largeur (±p) d'un espace entre le signal d'extraction et le centre dans la plage à interpoler, et pour générer la valeur interpolée pour chaque signal d'extraction sur la base de valeurs pondérées.

**5.** Appareil de mesure de signal selon l'une quelconque des revendications 1 à 4, **caractérisé en ce que** l'unité de conversion de données (100) comprend :

une unité (110) de conversion analogique/numérique (A/D) qui convertit le signal d'entrée en des données numériques ayant le nombre prédéterminé de bits avec les horloges ayant le cycle prédéterminé ts ;
une unité de détection de quadrature (121) qui effectue une opération de mélange à chaque composante obtenue en branchant une sortie de l'unité (110) de conversion (A/D) en deux composantes indépendamment de deux signaux locaux différents l'un de l'autre de 90° et ayant chacun une fréquence prédéterminée et délivre en sortie deux composantes en quadrature ayant des phases orthogonalisées à une fréquence correspondant à une différence entre la fréquence du signal d'entrée et la fréquence prédéterminée ;
une unité (122) de filtre à largeur de bande de résolution (RBW) qui effectue une limitation de largeur de bande prédéterminée aux deux composantes en quadrature délivrées en sortie de l'unité de détection de quadrature (121) et délivre en sortie deux composantes en quadrature résultantes de la limitation de largeur de bande ;
une unité de détection de carré (123) qui effectue une détection de carré aux deux composantes en quadrature résultantes de la limitation de largeur de bande délivrées en sortie de l'unité (122) de filtre (RBW) et délivre en sortie deux composantes en quadrature résultantes de la détection de carré ; et
une unité d'addition (124) qui additionne les deux composantes en quadrature résultantes de la détection de carré délivrées en sortie de l'unité de détection de carré (123).

**6.** Appareil de mesure de signal selon l'une quelconque des revendications 1 à 5, **caractérisé par** le fait de comprendre en outre :

une unité de mesure de probabilité d'amplitude (300),
l'une unité de mesure de probabilité d'amplitude (300) comprenant :

une mémoire (310) à laquelle on accède en utilisant le logarithme de sortie délivré en sortie à partir de l'additionneur (240) de l'unité de conversion logarithmique (200) en tant que valeur d'adresse (k) et qui délivre en sortie des données correspondant au logarithme de sortie préalablement stocké à l'adresse ;
un convertisseur de données (320) qui reçoit des données {$G^{n-1}$ (k) : n est le nombre de fois d'accès jusqu'à l'accès précédent) à l'adresse délivrée en sortie de la mémoire (310), convertit les données en des données {$G^{n}$(k)} comportant des informations exprimant le nombre de fois des derniers accès, et stocke les données à une adresse identique dans la mémoire (310) ;
une unité d'extraction de fréquence (330) qui reçoit les dernières données $G^{n}$(k) délivrées en sortie de la mémoire, convertit les données en un nombre de fois {n(k)} d'accès effectué à des adresses par le logarithme de sortie, et délivre en sortie le nombre de fois ; et
une unité de calcul de probabilité d'amplitude (340) qui calcule une probabilité d'amplitude sur la base du nombre de fois {N(k)} d'accès effectué par le logarithme de sortie délivré en sortie de l'unité d'extraction de fréquence et délivre en sortie la probabilité d'amplitude.

**7.** Appareil d'analyse de signal utilisant l'appareil de mesure de signal selon l'une quelconque des revendications 1 à 3, comprenant en outre :

une unité de commande d'affichage (400) qui affiche le logarithme en fonction des données de phase détectée délivrées en sortie de l'additionneur (240) de l'unité de conversion logarithmique (200) sur une unité d'affichage (600), **caractérisé en ce que**
l'unité de conversion de données (100) comprend :

une unité RF (900) qui balaye une largeur de bande de fréquence souhaitée à un signal haute fréquence (RF) d'entrée, et convertit ainsi le signal RF d'entrée sélectivement reçu en un signal (IF) à fréquence intermédiaire prédéterminé et délivre en sortie le signal IF ;

une unité (110) de conversion A/D qui convertit de l'analogique au numérique le signal IF délivré en sortie de l'unité RF (900) à des horloges générées dans le cycle prédéterminé ts et délivre en sortie le signal numérique en tant que données numériques ayant un nombre prédéterminé de bits; et

une unité de détection IF (120) comprenant :

une unité de détection de quadrature (121) qui effectue une opération de mélange à chaque composante obtenue par branchement d'une sortie de l'unité (110) de conversion A/D en deux composantes indépendamment de deux signaux locaux ayant des phases différentes l'une de l'autre de 90° et ayant chacun une fréquence prédéterminée et délivre en sortie deux composantes en quadrature ayant des phases orthogonalisées à une fréquence correspondant à une différence entre la fréquence du signal d'entrée et la fréquence prédéterminée ;

une unité (122) de filtre à largeur de bande de résolution (RBW) qui effectue une limitation de largeur de bande prédéterminée aux deux composantes en quadrature délivrées en sortie de l'unité de détection de quadrature (121) et délivre en sortie deux composantes en quadrature résultantes de la limitation de largeur de bande ;

une unité de détection de carré (123) qui effectue une détection de carré aux deux composantes en quadrature résultantes de la limitation de largeur de bande délivrées en sortie de l'unité (122) de filtre (RBW) et délivre en sortie deux composantes en quadrature résultantes de la détection de carré ; et

une unité d'addition (124) qui additionne les deux composantes en quadrature résultantes de la détection de carré délivrées en sortie de l'unité de détection de carré (123) et délivre en sortie des données de phase détectée.

8. Appareil d'analyse de signal selon la revendication 7, **caractérisé en ce qu'**il comprend en outre :

une unité de mesure de probabilité d'amplitude (300),
l'unité de mesure de probabilité d'amplitude (300) comprenant :

une mémoire (310) à laquelle on accède en utilisant le logarithme délivré en sortie de l'additionneur (240) de l'unité de conversion logarithmique (200) en tant que valeur d'adresse (k) et qui délivre en sortie des données correspondant au logarithme de sortie préalablement stocké à l'adresse ;

un convertisseur de données (320) qui reçoit des données $\{G^{n-1}(k)$ : n est le nombre de fois d'accès jusqu'à l'accès précédent$\}$ à l'adresse délivrée en sortie de la mémoire (310), convertit les données en des données $(G^n(k))$ comportant des informations exprimant le nombre de fois des derniers accès, et stocke les données à des adresses identiques dans la mémoire (310) ;

une unité d'extraction de fréquence (330) qui reçoit les dernières données $G^n(k)$ délivrées en sortie de la mémoire (310), convertit les données en un nombre de fois $\{n(k)\}$ d'accès effectué à des adresses par le logarithme de sortie, et délivre en sortie le nombre de fois ; et

une unité de calcul de probabilité d'amplitude (340) qui calcule une probabilité d'amplitude sur la base du nombre de fois $\{N(k)\}$ d'accès effectué par le logarithme de sortie délivré en sortie de l'unité d'extraction de fréquence (330), et délivre en sortie la probabilité d'amplitude, et **caractérisé en ce que**

l'unité de commande d'affichage (400) est configurée pour amener l'unité d'affichage (600) à afficher sélectivement le logarithme en fonction des données de phase détectée délivrées en sortie de l'additionneur (240) de l'unité de conversion logarithmique (200) ou de la probabilité d'amplitude délivrée en sortie de l'unité de calcul de probabilité d'amplitude (340) de l'unité de mesure de probabilité d'amplitude (300) sur des coordonnées dont l'abscisse indique des fréquences dans la bande de fréquence souhaitée.

9. Appareil d'analyse de signal selon la revendication 7 ou B, **caractérisé en ce que**
l'unité de commande d'affichage (400) est configurée pour afficher sélectivement le logarithme correspondant aux données de phase détectée délivrées en sortie de l'additionneur (240) de l'unité de conversion logarithmique (200) ou de la probabilité d'amplitude délivrée en sortie de l'unité de calcul de probabilité d'amplitude (340) de l'unité de mesure de probabilité d'amplitude (300) de sorte que les fréquences dans la bande de fréquence souhaitée sur l'abscisse soient affichées par l'une des fréquences correspondant à un intervalle du cycle prédéterminé ts et des fréquences correspondant à un intervalle d'un cycle ts/N.

10. Appareil d'analyse de signal selon la revendication 9, **caractérisé en ce que**
l'unité de commande d'affichage (400) est configurée pour afficher sélectivement le logarithme en fonction des données de phase détectée délivrées en sortie de l'additionneur (240) de l'unité de conversion logarithmique (200) ou de la probabilité d'amplitude délivrée en sortie de l'unité de calcul de probabilité d'amplitude (340) de l'unité de mesure de probabilité d'amplitude (300) de sorte que les fréquences dans la largeur de bande de fréquence souhaitée sur l'abscisse soient affichées par des fréquences correspondant à un intervalle du cycle prédéterminé ts et certaines des fréquences soient amplifiées et affichées par les fréquences correspondant à l'intervalle du cycle ts/N.

**11.** Appareil d'analyse de signal selon la revendication 9, **caractérisé en ce que**
l'unité d'interpolation (500) est configurée pour désigner des données de phase détectée à un centre (mts) d'une plage à interpoler par les données de phase détectée délivrées en sortie à des intervalles de 1/N dans un cycle prédéterminé ts, pour générer un signal d'extraction mts$\pm$p, p étant -1/2+h/N, et h étant un entier se trouvant dans la plage allant de 0 à moins de N, ayant un cycle ts/N dans la plage à interpoler, pour pondérer les données de phase détectée {p(mts)} au centre de la plage à interpoler et des données de phase détectée les plus proches {p((m-1)ts), p((m+1)ts)} correspondant à une largeur ($\pm$p) d'un espace entre le signal d'extraction et le centre de la plage à interpoler, et pour générer le signal d'extraction pour chaque valeur interpolée sur la base des valeurs pondérées.

**12.** Procédé de mesure de signal comprenant les étapes qui consistent :

à préparer une unité de conversion de données (100) et une unité de conversion logarithmique (200) ;
à amener l'unité de conversion de données (100) à convertir un signal d'entrée en des données numériques ayant un nombre prédéterminé de bits à des horloges ayant un cycle prédéterminé ts et à délivrer en sortie des données de phase détectée en effectuant une détection de carré de deux composantes en quadrature des données numériques et en ajoutant les composantes en quadrature, élevées au carré, résultantes, et
à amener l'unité de conversion logarithmique (200) à effectuer la conversion logarithmique des données de phase détectée ;
**caractérisé par** le fait de comprendre en outre les étapes qui consistent :

à préparer un séparateur exposant-mantisse (210), une table de calcul de mantisse (220), une unité de sortie d'exposant (230), et un additionneur (240) ;
à amener le séparateur exposant-mantisse (210) à recevoir les données de phase détectée et à séparer les données de phase détectée en des données de mantisse exprimant une partie de mantisse des données de phase détectée et des données d'exposant exprimant une partie d'exposant des données de phase détectée pour délivrer en sortie les données de mantisse et les données d'exposant ;
à délivrer en sortie un logarithme de sortie correspondant à des données de mantisse préalablement stockées à partir de la table de calcul de mantisse (220) à accéder par les données de mantisse ;
à amener l'unité de sortie d'exposant (230) à délivrer en sortie un logarithme correspondant aux données d'exposant sur la base des données d'exposant ;
à amener l'additionneur (240), en vue d'obtenir un logarithme de sortie correspondant à l'amplitude du signal d'entrée, à ajouter le logarithme correspondant aux données de mantisse au logarithme correspondant aux données d'exposant et à délivrer en sortie un logarithme de sortie correspondant aux données de phase détectée,
à préparer une unité d'interpolation (500) ; et
à amener l'unité d'interpolation (500) à recevoir des horloges générées dans le cycle prédéterminé ts, à interpoler les données de phase détectée délivrées en sortie de l'unité de conversion de données (100) à un intervalle de ts/N avec N étant un entier dans le cycle prédéterminé ts, et à transmettre une valeur interpolée au séparateur exposant-mantisse (210).

**13.** Procédé de mesure de signal selon la revendication 12, **caractérisé en ce que**
l'unité de sortie d'exposant (230) comprend :

une table de calcul d'exposant (230) qui est accessible par les données d'exposant délivrées en sortie du séparateur exposant-mantisse (210) et qui délivre en sortie un logarithme correspondant aux données d'exposant préalablement stockées.

**14.** Procédé de mesure de signal selon la revendication 12 ou 13, **caractérisé en ce que**
le séparateur exposant-mantisse (210) comprend :

un décideur (211) qui reçoit les données de phase détectée délivrées en sortie de l'unité de conversion de données (100), discrimine le bit le plus significatif des données de phase détectée reçues par un circuit logique (211a, 211b), et délivre en sortie un résultat de discrimination ;
un sélecteur de mantisse (212) qui sélectionne des données d'une pluralité de bits comportant des données d'un nombre prédéterminé de bits inférieurs à partir du résultat de discrimination du bit le plus significatif délivré en sortie du décideur (211) et délivre en sortie les données en tant que données de mantisse exprimant la partie de mantisse sur la base de la pluralité de données de bits sélectionnées ; et

un dispositif de détermination d'exposant (213) qui convertit le bit le plus significatif en des données d'identification identifiables sur la base du résultat de discrimination du bit le plus significatif délivré en sortie du décideur (211) et délivre en sortie les données d'identification en tant que données d'exposant exprimant la partie d'exposant.

**15.** Procédé de mesure de signal selon la revendication 14, **caractérisé en ce que**

l'unité d'interpolation (500) est configurée pour désigner des données de phase détectée au centre (mts) d'une plage à interpoler par les données de phase détectée délivrées en sortie à des intervalles de 1/N dans le cycle prédéterminé ts, pour générer un signal d'extraction mts±p, p étant -1/2+h/N, et h étant un entier se trouvant dans la plage allant de 0 à moins de N, ayant un cycle ts/N dans la plage à interpoler, pour pondérer les données de phase détectée {p(mts)} au centre de la plage à interpoler et des données de phase détectée les plus proches {p((m-1)ts), p((m-H1)ts)} en fonction de la largeur (±p) d'un espace entre le signal d'extraction et le centre dans la plage à interpoler, et pour générer la valeur interpolée pour chaque signal d'extraction sur la base de valeurs pondérées.

**16.** Procédé de mesure de signal selon l'une quelconque des revendications 12 à 15, **caractérisé en ce que**

l'unité de conversion de données (100) comprend :

une unité (110) de conversion analogique/numérique (A/D) qui convertit le signal d'entrée en des données numériques ayant le nombre prédéterminé de bits à des horloges générées dans le cycle prédéterminé ts ;

une unité de détection de quadrature (121) qui effectue une opération de mélange à chaque composante obtenue en branchant une sortie de l'unité (110) de conversion analogique/numérique (A/D) en deux composantes indépendamment de deux signaux locaux ayant des phases différentes l'une de l'autre de 90° et ayant chacun une fréquence prédéterminée et délivre en sortie deux composantes en quadrature ayant des phases orthogonalisées à une fréquence correspondant à une différence entre la fréquence du signal d'entrée et la fréquence prédéterminée ;

une unité (122) de filtre à largeur de bande de résolution (RBW) qui effectue une limitation de largeur de bande prédéterminée aux deux composantes en quadrature délivrées en sortie de l'unité de détection de quadrature (121) et délivre en sortie les composantes en quadrature résultantes ;

une unité de détection de carré (123) qui effectue une détection de carré aux deux composantes en quadrature délivrées en sortie de l'unité (122) de filtre (RBW) et délivre en sortie deux composantes en quadrature résultantes ; et

une unité d'addition (124) qui additionne les deux composantes en quadrature délivrées en sortie de l'unité de détection de carré (123).

**17.** Procédé de mesure de signal selon l'une quelconque des revendications 12 à 16, **caractérisé par** le fait de comprendre en outre les étapes qui consistent :

à préparer une unité de mesure de probabilité d'amplitude (300) comprenant une mémoire (310), un convertisseur de données (320), une unité d'extraction de fréquence (330), et une unité de calcul de probabilité d'amplitude (340) ;

à délivrer en sortie des données correspondant au logarithme de sortie préalablement stocké à l'adresse à partir de la mémoire (310) à laquelle on accède en utilisant le logarithme de sortie en tant que valeur d'adresse (k) ;

à amener le convertisseur de données (320) à recevoir des données ($G^{n-1}$ (k) : n est le nombre de fois d'accès jusqu'à l'accès précédent) à l'adresse délivrée en sortie de la mémoire (310), à convertir les données en des données {$G^n(k)$} comportant des informations exprimant le nombre de fois des derniers accès, et à stocker les données à une adresse identique dans la mémoire (310) ;

à amener l'unité d'extraction de fréquence (330) à recevoir les dernières données $G^n(k)$ délivrées en sortie de la mémoire et à convertir les données en un nombre de fols {n(k)} d'accès effectué à des adresses par le logarithme de sortie pour délivrer en sortie le nombre de fois ; et

à amener l'unité de calcul de probabilité d'amplitude (340) à calculer une probabilité d'amplitude sur la base de la sortie du nombre de fois {N(k)} d'accès effectué par le logarithme de sortie et à délivrer en sortie la probabilité d'amplitude.

**18.** Procédé d'analyse de signal utilisant le procédé de mesure de signal selon l'une quelconque des revendications 12 à 14, comprenant en outre les étapes qui consistent :

à préparer une unité (900) haute fréquence (RF), une unité (110) de conversion analogique/numérique (A/D),

36

une unité de détection IF (120), et une unité de conversion logarithmique (200) ;

à amener l'unité RF (900) à balayer une largeur de bande de fréquence souhaitée à un signal RF d'entrée, et à convertir ainsi le signal RF d'entrée sélectivement reçu en un signal à fréquence intermédiaire prédéterminé (IF) et à délivrer en sortie le signal à fréquence intermédiaire ; et

à amener l'unité (110) de conversion A/D à convertir de l'analogique au numérique le signal IF à des horloges générées dans le cycle prédéterminé ts et à délivrer en sortie le signal numérique en tant que données numériques ayant un nombre prédéterminé de bits ;

à préparer une unité de détection IF (120) comprenant une unité de détection de quadrature (121), une unité (122) de filtre à largeur de bande de résolution (RBW), une unité de détection de carré (123), et une unité d'addition (124) ;

à amener l'unité de détection de quadrature (121) à effectuer une opération de mélange à chaque composante obtenue par branchement d'une sortie de l'unité de conversion A/D en deux composantes indépendamment de deux signaux locaux ayant des phases différentes l'une de l'autre de 90° et ayant chacun une fréquence prédéterminée et à délivrer en sortie deux composantes en quadrature ayant des phases orthogonalisées à une fréquence correspondant à une différence entre la fréquence du signal d'entrée et la fréquence prédéterminée ;

à amener l'unité (122) de filtre (RBW) à effectuer une limitation de largeur de bande prédéterminée aux deux composantes en quadrature et à délivrer en sortie les composantes en quadrature résultantes ;

à amener l'unité de détection de carré (123) à effectuer une détection de carré pour les deux composantes en quadrature soumises à la limitation de largeur de bande et délivrer en sortie deux composantes en quadrature résultantes de la détection de carré ;

à amener l'unité d'addition (124) à additionner les deux composantes en quadrature délivrées en sortie de l'unité de détection de carré (123) et à les délivrer en sortie en tant que données de phase détectée ;

à préparer une unité d'affichage (600) et une unité de commande d'affichage (400) ; et

à amener l'unité de commande d'affichage (400) à afficher le logarithme en fonction des données de phase détectée délivrées en sortie de l'additionneur (240) de l'unité de conversion logarithmique (200) sur l'unité d'affichage (600),

**caractérisé par** le fait de comprendre en outre les étapes qui consistent :

à préparer une unité de conversion logarithmique (200) comprenant un séparateur exposant-mantisse (210), une table de calcul de mantisse (220), une unité de sortie d'exposant (230), et un additionneur (240) ;

à amener le séparateur exposant-mantisse (210) à recevoir les données de phase détectée et à séparer les données de phase détectée en des données de mantisse exprimant une partie de mantisse des données de phase détectée et des données d'exposant exprimant une partie d'exposant des données de phase détectée et à délivrer en sortie les données de mantisse et les données d'exposant ;

à délivrer en sortie un logarithme correspondant aux données de mantisse préalablement stockées à partir de la table de calcul de mantisse (220) qui est accessible par les données de mantisse ;

à amener l'unité de sortie d'exposant (230) à délivrer en sortie un logarithme correspondant aux données d'exposant sur la base des données d'exposant ;

à amener l'additionneur (240) à ajouter le logarithme correspondant aux données de mantisse délivrées en sortie de la table de calcul de mantisse (220) au logarithme correspondant aux données d'exposant délivrées en sortie de l'unité de sortie d'exposant (230) et à délivrer en sortie un logarithme en fonction des données de phase détectée ; et

à amener l'unité de commande d'affichage (400) à afficher le logarithme en fonction des données de phase détectée sur l'unité d'affichage (600).

19. Procédé d'analyse de signal selon la revendication 18, **caractérisé par** le fait de comprendre en outre les étapes qui consistent :

à préparer une unité de mesure de probabilité d'amplitude (300) comprenant une mémoire (310), un convertisseur de données (320), une unité d'extraction de fréquence (330), et une unité de calcul de probabilité d'amplitude (340) ;

à délivrer en sortie des données correspondant au logarithme de sortie préalablement stocké à l'adresse à partir de la mémoire (310) à laquelle on accède en utilisant le logarithme de sortie en tant que valeur d'adresse (k) ;

à amener le convertisseur de données (320) à recevoir des données $\{G^{n-1}(k)$ : n est le nombre de fois d'accès jusqu'à l'accès précédent} à l'adresse délivrée en sortie de la mémoire (310), à convertir les données en des données $\{G^n\{k\}\}$ comportant des informations exprimant le nombre de fois des derniers accès, et à stocker les données à une adresse identique dans la mémoire (310) ;

à amener l'unité d'extraction de fréquence (330) à recevoir les dernières données $G^n(k)$ délivrées en sortie de la mémoire (310), à convertir les données en un nombre de fois $\{n(k)\}$ d'accès effectué à des adresses par le logarithme de sortie, et à délivrer en sortie le nombre de fois ; et

à amener l'unité de calcul de probabilité d'amplitude (340) à calculer une probabilité d'amplitude sur la base de la sortie du nombre de fois $\{N(k)\}$ d'accès effectué par le logarithme de sortie ; et

à amener l'unité de commande d'affichage (400) à afficher sélectivement le logarithme en fonction des données de phase détectée délivrées en sortie de l'additionneur (240) de l'unité de conversion logarithmique (200) ou de la probabilité d'amplitude délivrée en sortie de l'unité de calcul de probabilité d'amplitude (340) de l'unité de mesure de probabilité d'amplitude (300) sur des coordonnées dont l'abscisse indique des fréquences dans la bande de fréquence souhaitée.

**20.** Procédé d'analyse de signal selon la revendication 18 ou 19, **caractérisé par** le fait de comprendre en outre l'étape qui consiste :

à amener l'unité de commande d'affichage (400) à afficher sélectivement le logarithme en fonction des données de phase détectée ou de la probabilité d'amplitude sur l'unité d'affichage (600) de sorte que les fréquences dans la bande de fréquence souhaitée sur l'abscisse soient affichées par l'une des fréquences correspondant à un intervalle du cycle prédéterminé ts et des fréquences correspondant à un intervalle d'un cycle ts/N.

**21.** Procédé d'analyse de signal selon la revendication 20, **caractérisé en ce que** l'unité de commande d'affichage (400) est configurée pour afficher sélectivement le logarithme en fonction des données de phase détectée délivrées en sortie de l'additionneur (240) de l'unité de conversion logarithmique (200) ou de la probabilité d'amplitude délivrée en sortie de l'unité de calcul de probabilité d'amplitude (340) de l'unité de mesure de probabilité d'amplitude (300) de sorte que les fréquences dans la bande de fréquence souhaitée sur l'abscisse soient affichées par les fréquences correspondant à un intervalle du cycle prédéterminé ts et des fréquences correspondant à un intervalle d'un cycle ts/N.

**22.** Procédé d'analyse de signal selon la revendication 20, **caractérisé en ce que** l'unité d'interpolation (500) est configurée pour désigner des données de phase détectée au centre (mts) d'une plage à interpoler par les données de phase détectée délivrées en sortie à des intervalles de 1/N dans le cycle prédéterminé ts, pour générer un signal d'extraction mts$\pm$p, p étant -1/2+h/N, et h étant un entier se trouvant dans la plage allant de 0 à moins de N, ayant un cycle ts/N dans la plage à interpoler, pour pondérer les données de phase détectée $\{p(mts)\}$ au centre de la plage à interpoler et des données de phase détectée les plus proches $\{p((m-1)ts), p((m+1)ts)\}$ en fonction de la largeur ($\pm$p) d'un espace entre le signal d'extraction et le centre dans la plage à interpoler, et pour générer la valeur interpolée pour chaque signal d'extraction sur la base des valeurs pondérées.

FIG. 1

100: Data converting unit
110 A/D converting unit
$f_{IN} \pm B/2$ Input signal
ts
111
120: IF detecting unit
121: Quadrature detecting unit
121a, 121b
90° Phase shifting unit
121c
$f_{IF}$
121d
122: RBW filter unit
122a, 122b
123: Square detecting unit
123a, 123b
124 $\Sigma$
$\rho \cong M2^E$
200 Log converting unit
210 Exponent-mantissa separator (floating point)
M
$2^E$
220 Mantissa calculating table $(10/\Delta) \times (\log M)$
230 Exponent calculating table $E/\Delta \times \log 2$
240 Adder
$10/\Delta \times (\log \rho)$
300 APD
ts
400 Display control unit
600 Display unit

FIG. 2

2L-bit data
Decider
211
Selection signal
212 Mantissa selector — Data m expressing mantissa part M
213 Exponent determiner — Data d expressing exponent $2^E$

$(d \geqq 2^{2L-1})$ $(d \geqq 2^{2L-2})$ $(d \geqq 2^{L+2})$ $(d \geqq 2^{L+1})$ $(d \geqq 2^L)$ $(d \geqq 2^{L-1})$ $(d \geqq 2^{L-2})$ $(d \geqq 2^2)$ $(d \geqq 2^1)$ $(d \geqq 2^0)$

211a

$(c \geqq 2^{L-1})$ $(c \geqq 2^{L-2})$ $(c \geqq 2^2)$ $(c \geqq 2^1)$ $(c \geqq 2^0)$

211c

MSB

L-1

L-2

...

...

Data c

Logical circuit

Lower-bit control gate

1

0

Logical circuit

$(c \geqq 2^{L-1})$ $(c \geqq 2^{L-2})$ $(c \geqq 2^2)$ $(c \geqq 2^1)$ $(c \geqq 2^0)$

2L-bit input data

L-1

L-2

...

...

Data c

Logical circuit

1

LSB

0

211b

FIG. 3

FIG. 4A

| c | $c \geqq 2^0$ | $c \geqq 2^1$ |
|---|---|---|
| 0 | 0 | 0 |
| 1 | 1 | 0 |
| 2 | 1 | 1 |
| 3 | 1 | 1 |

FIG. 4B

FIG. 4C

F I G. 5

ρ(t)= I² + Q² (Envelope curve)

Magnitude (linear)

Indicate sampling point

Point A

FIG. 6A

Magnitude (log)

Log ρ(t)

Point A

m-1   m   m+1

B

Interpolation range near point m

ts=1/fs

Magnification of graduation   t

Value of p
(fsr= 10)   p ⟹  -0.5 -0.4 -0.3 -0.2 -0.1  0  0.1  0.2  0.3  0.4

|m

FIG. 6B

Magnitude (log)

C

Frequency F

Span Δf = ts = 1/fs

FIG. 6C

Register unit ~510

$\rho(m+2)$ → Register 1 → Register 2 → Register 3

Sample cycle: ts

$\rho[(m+1)ts]$   $\rho[(m)ts]$   $\rho[(m-1)ts]$

541

$1/2 \cdot p(p+1)$   530

$p^2$

Coefficient calculating table $(p=-1/2+h/osr)$

$1/2 \cdot p(p-1)$

542

544   545

543

540

546

Adding unit

h

520

Interpolation position signal generator (Output value h{0, 1, 2,..., osr-1} every ts/osr)

ts →

$\rho[(m+p)ts] = 1/2 \cdot p(p+1) \cdot \rho[(m+1)ts] + (1-p^2) \cdot [(m)ts] + 1/2 \cdot p(p-1) \cdot \rho[(m-1)ts]$

FIG. 7

F I G. 8A

☒ :APD is 90% or more
◣ :APD is 50 to less than 90%
☐ :APD is 10 to less than 50%
▨ : APD is less than 10%

F I G. 8B

F I G. 9

FIG.10

FIG. 11

FIG. 12

| c | d | Deciding result |
|---|---|---|
| 1 | 0 | 00000001 |
| 2, 3 | 1 | 0000001_1_ |
| 4-7 | 2 | 000001_11_ |
| 8-15 | 3 | 00001_111_ |
| 16-31 | 4 | 0001_1111_ |
| 32-63 | 5 | 001_11111_ |
| 61-127 | 6 | 01_111_111 |
| 128-255 | 7 | 1_1111_111 |

F I G. 13

200

**Log converting unit**

124
Adding unit

210
Exponent-mantissa separator (floating point)

M

220
Mantissa calculating table

$(10/\Delta) \times (\log M)$

240
Adder

$(10/\Delta) \times (\log \rho)$

To display control unit 400 or APD 300

230a

E based on $2^E$

230b
Constant value storage unit

$\log 2/\Delta$

$E/\Delta \times \log 2$

F I G. 14

48

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4771232 A
- JP 9257843 A
- JP 7321582 A
- JP 10170574 A
- JP 2920828 B
- JP 10164260 A
- JP 11337600 A
- US 6509728 B

**Non-patent literature cited in the description**

- **MASAHARU UCHINO et al.** Real-time Measurement of Noise Statistics. *IEEE TRANSACTIONS ON ELECTROMAGNETIC COMPATIBILITY,* November 2001, vol. 43 (4), 629-636
- **MASAHARU UCHINO et al.** SIMULTANEOUS MEASUREMENTS of DISTURBANCE APD, CRD and PDD. *EMC '99 Tokyo International Symposium On Electromagnetic Compatibility,* May 1999, 177-180